# EUROPEAN PATENT SPECIFICATION

(11) **EP 3 809 471 B1**
(45) Date of publication and mention of the grant of the patent: **13.03.2024**
(21) Application number: 19210196.2
(22) Date of filing: 19.11.2019
(51) Int. Cl.: H01L 31/05, H01L 31/0224

(54) **AUTOMATED ASSEMBLY AND MOUNTING OF SOLAR CELLS ON SPACE PANELS**
AUTOMATISIERTE MONTAGE UND MONTAGE VON SOLARZELLEN AUF RAUMFELDERN
ASSEMBLAGE ET MONTAGE AUTOMATISÉ DE CELLULES SOLAIRES SUR DES PANNEAUX SPATIAUX

(30) Priority: 17.10.2019 US 201916656279
(43) Date of publication of application: 21.04.2021
(73) Proprietor: SolAero Technologies, Corp., Albuquerque NM 87123 (US)
(72) Inventor: Clevenger, Marvin B., Albuquerque, NM 87111 (US)
(74) Representative: Rummler, Felix

(56) References cited:
- EP-A1- 3 331 028
- CN-A- 107 394 011
- US-A1- 2013 052 773
- US-A1- 2018 219 109

## Description

### BACKGROUND OF THE DISCLOSURE

### Field of the Disclosure

The present disclosure relates to the field of photovoltaic solar arrays, and more particularly to fabrication processes utilizing, for example, multijunction solar cells based on III-V semiconductor compounds mounted and interconnected on a panel support or substrate using automated processes starting with the fabricated semiconductor wafer and continuing to the finished panel.

### Description of the Related Art

Solar power from photovoltaic cells, also called solar cells, has been predominantly provided by silicon semiconductor technology. In the past several years, however, high-volume manufacturing of III-V compound semiconductor multijunction solar cells for space applications has accelerated the development of such technology not only for use in space but also for terrestrial solar power applications. Compared to silicon, III-V compound semiconductor multijunction devices have greater energy conversion efficiencies and generally more radiation resistance, although they tend to be more complex to manufacture. Typical commercial III-V compound semiconductor multijunction solar cells have energy efficiencies that exceed 27% under one sun, air mass 0 (AMO), illumination, whereas even the most efficient silicon technologies generally reach only about 18% efficiency under comparable conditions. Under high solar concentration (e.g., 500X), commercially available III-V compound semiconductor multijunction solar cells in terrestrial applications (at AM1.5D) have energy efficiencies that exceed 37%. The higher conversion efficiency of III-V compound semiconductor solar cells compared to silicon solar cells is in part based on the ability to achieve spectral splitting of the incident radiation through the use of a plurality of photovoltaic regions with different band gap energies, and accumulating the current from each of the regions.

In satellite and other space related applications, the size, mass and cost of a satellite power system are dependent on the power and energy conversion efficiency of the solar cells used. Putting it another way, the size of the payload and the availability of on-board services are proportional to the amount of power provided. Thus, as payloads become more sophisticated, the power-to-weight ratio of a solar cell becomes increasingly more important, and there is increasing interest in lighter weight, "thin film" type solar cells having both high efficiency and low mass.

Space applications frequently use high efficiency solar cells, including multijunction solar cells based on III-V compound semiconductors. Typical III-V compound semiconductor solar cells are fabricated on a semiconductor wafer in vertical, multijunction structures. The individual solar cells or wafers are then disposed in horizontal arrays, with the individual solar cells connected together in an electrical series and/or parallel circuit. The shape and structure of an array, as well as the number of cells it contains, are determined in part by the desired output voltage and current.

Conventional space solar array panels at present are most often comprised of a relatively densely packed arrangement of large solar cells formed from group III-V compound semiconductor devices mounted on a rigid supporting panel and operating without lenses for optical concentration of sunlight. A conventional space solar array panel may include a support, space solar cells disposed on the support, interconnection components for connecting the solar cells, bypass diodes connected to the individual solar cells, and blocking diodes connected to the terminations of strings of solar cells.

Solar panels are generally formed by combining a large number of solar cells in an array. Individual solar cells, frequently with a rectangular or generally square- shape and sometimes with cropped corners, are connected in series to form a string of solar cells, whereby the number of solar cells used in the string determines the output voltage. Solar cells or strings of solar cells can also be interconnected in parallel, so as to increase the output current. In the field of space applications, individual solar cells are provided with interconnects and cover glass so as to form so-called CICs (Cell-Interconnect-Cover Glass) assemblies, which are then combined to form an array. Conventionally, these large solar cells have been mounted on a support and interconnected using a substantial amount of manual labor. For example, first individual CICs are produced with each interconnect individually welded to each cell, and each cover glass individually mounted. Then, these CICs are connected in series to form strings, generally in a substantially manual manner, including welding or soldering steps. Then, these strings are applied to a panel or substrate and interconnected, in a process that includes the application of adhesive, wiring, and other assembly steps.

Close packing of the large solar cells on the space solar array panel is challenging due to requirement for interconnection of the solar cells to form a series circuit and to implement and interconnect the bypass diodes. An additional challenge can sometimes reside in the need to interconnect a plurality of strings of series connected solar cells in parallel. All of this has traditionally been carried out in a manual and substantially labor-intensive manner.

There is a continuing need for improved methods of manufacturing and assembling individual solar cells into photovoltaic solar arrays and finished panels that can result in decreases in cost and/or increases in performance. US 2018/219109 A1 discloses a method of fabricating a solar panel, as known in the prior art.

### SUMMARY OF THE DISCLOSURE

### Objects of the Disclosure

The subject matter of the present invention is defined in claim 1.

It is an object of the present disclosure to provide an automated process for producing solar power panels for space applications.

It is another object of the present disclosure to provide a set of automated assembly tools for producing solar power panels for space applications.

It is another object of this disclosure to provide elements of configuration and construction of solar panels that impart to it the properties and qualities required in order to function in extreme environments and that also enable them to be assembled in an automated fashion.

It is another object of this disclosure to provide designs and methods for interconnection of solar cells in various, interchangeable and adjustable series-parallel arrangements such that building blocks of common design can be assembled in an automated fashion into solar panels capable of servicing applications that require custom or unique current-voltage (power) inputs.

It is another object of this disclosure to provide designs, configurations and constructions of solar cells and solar panels, as well as methods and apparatus, that enable solar panels to be built from a range of photovoltaic technologies, instead of being limited in application to only one or a subset of technologies.

It is another object of this disclosure to provide methods and apparatus for assembly of solar cells that are compatible with a range of photovoltaic technologies of common design.

It is another object of the disclosure to provide a supply ribbon of interconnection elements that can be used in an automated process to form a solar array panel by automatically placing and interconnecting the solar cell on a carrier or support fixture.

It is another object of the disclosure to provide for an assembly line architecture and operational method that facilitates automation of at least certain steps of the assembly process for manufacture of solar cell assemblies, CICs, and panels of interconnected CICs.

Some implementations of the present disclosure may incorporate or implement fewer of the aspects and features noted in the foregoing objects.

### Features of the Disclosure

Briefly, and in general terms, the present disclosure provides a method of fabricating a solar cell panel comprising: providing first and second solar cells each having at least first and second spaced apart electrical contacts of first polarity on the top or light-facing surface thereof, and a third electrical contact of a second polarity on the bottom surface thereof; automatically positioning the first solar cell to a first position with the bottom surface of the first solar cell positioned on a first assembly fixture; automatically positioning a first electrically conductive end portion of an electrical interconnect fabrication ribbon over the first solar cell positioned on the first assembly fixture; automatically bonding a first end portion of a first electrical interconnect ribbon disposed on the interconnect fabrication ribbon to the first electrical contact on the first solar cell; moving the first solar cell to a second position adjacent to the first position on the first assembly fixture; positioning a second solar cell adjacent to the first solar cell on the first assembly fixture over the interconnect fabrication ribbon; and bonding a second electrically conductive end portion of the first electrical interconnect to the third electrical contact of the second solar cell, thereby making a series electrical connection of the first solar cell with the second solar cell.

In certain embodiments, the solar cell is selected from the group consisting of (i) single junction, polycrystalline or monocrystalline silicon, hetero- or homo-junction; or (ii) GaAs-based single junction, to include variants that contain small amounts of indium (InₓGa₁₋ₓAs) with 0<x<1, in order to adjust bandgap, lattice parameter or spectral responsivity; or (iii) GaAs-based dual junction, to include variants that contain small amounts of indium (InₓGa₁₋ₓP or InₓGa₁₋ₓAs) with 0<x<1, and or small amounts of aluminum (AlₓIn_{y}Ga_{1-x-y}P or AlₓIn_{y}Ga_{1-x-y}As), with 0<x<1, 0<y<1, in order to adjust bandgap, lattice parameter or spectral responsivity; or (iv) germanium-based dual junction, to include variants that contain small amounts of indium (InₓGa₁₋ₓP or InₓGa₁₋ₓAs) with 0<x<1, and or small amounts of aluminum (AlₓIn_{y}Ga_{1-x-y}P or AlₓIn_{y}Ga_{1-x-y}As), with 0<x<1, 0<y<1, in order to adjust bandgap, lattice parameter or spectral responsivity; or (v) germanium-based triple junction, 4-junction, or 5-junction solar cells.

In certain embodiments, the solar cell is a multijunction solar cell comprising an upper first solar subcell composed of indium gallium aluminum phosphide and having a first band gap in the range of 2.05 to 2.15 eV; a second solar subcell adjacent to said first solar subcell including an emitter layer composed of indium gallium phosphide or aluminum gallium arsenide, and a base layer composed of aluminum gallium arsenide and having a second band gap in the range of 1.70 to 1.8 eV and being lattice matched with the upper first solar subcell, wherein the emitter and base layers of the second solar subcell form a photoelectric junction; and a third solar subcell adjacent to said second solar subcell and composed of germanium and having a third band gap of approximately 0.67 eV.

In certain embodiments, the solar cell is a multijunction solar cell comprising an upper first solar subcell composed of indium gallium aluminum phosphide and having a first band gap in the range of 2.05 to 2.15 eV; a second solar subcell adjacent to said first solar subcell including an emitter layer composed of indium gallium phosphide or aluminum gallium arsenide, and a base layer composed of aluminum gallium arsenide and having a second band gap in the range of approximately 1.70 to 1.8 eV and being lattice matched with the upper first solar subcell, wherein the emitter and base layers of the second solar subcell form a photoelectric junction; a third solar subcell adjacent to said second solar subcell and composed of indium gallium arsenide and having a third band gap of approximately 1.41 eV and being lattice matched with the second solar subcell; and a fourth solar subcell adjacent to said third solar subcell and composed of germanium and having a fourth band gap of approximately 0.67 eV.

In certain embodiments, the interconnect fabrication ribbon is composed of a silver or a silver alloy material.

In certain embodiments, the interconnect fabrication ribbon is composed of a nickel iron alloy material.

In certain embodiments, the third electrical contact on the bottom surface of the solar cell is a metal layer covering the entire backside surface of the solar cell.

In certain embodiments, the third electrical contact on the bottom surface of the solar cell is a layer composed of titanium and/or silver and/or gold or other metals covering a portion of the entire backside surface of the solar cell.

In certain embodiments, the first and second electrical contacts on the top surface of the solar cell comprise two or more parallel strips extending from one edge of the solar cell to the opposite edge.

In certain embodiments in which the solar cell is composed of silicon, the third electrical contact on the bottom surface of the solar cell is a copper layer covering the entire backside surface of the solar cell.

In certain embodiments, the first and second electrical contacts on the top surface of the solar cell comprise two or more equally spaced parallel strips extending along the surface of the solar cell along its length.

In certain embodiments, the formation of the back metal or bottom surface of the solar cell is formed by electroplating, vacuum evaporation, or similar technique.

In certain embodiments, a first interconnect fabrication ribbon is automatically positioned over one of the parallel contact strips, and a second interconnect fabrication ribbon is automatically positioned over the second of the parallel contact strips.

In certain embodiments, the first and second interconnection ribbons are automatically bonded to the first and second parallel contact strips by ultrasonic or parallel gap welding.

In certain embodiments, the second portion of the first electrical interconnect ribbon is bonded to the third electrical contact of the second solar cell by ultrasonic or parallel gap welding.

In certain embodiments, there further comprises automatically moving the first solar cell to a third position adjacent to the second position on the assembly fixture; and simultaneously moving the second solar cell to the second position adjacent to the first position on the assembly fixture; positioning a third solar cell adjacent to the second solar cell on the assembly fixture and repeating the process of automatically positioning a third portion of an interconnect fabrication ribbon over the third solar cell positioned on the first assembly fixture; and automatically bonding the third portion of a second electrical interconnect disposed on the interconnect fabrication ribbon to the first electrical contact on the third solar cell.

In certain embodiments, the interconnect fabrication ribbon extending between the second portion and the third portion is conductive so that the first, second, and third solar cells are connected in an electrical series.

In certain embodiments, there further comprises automatically transferring the series interconnected solar cells to a second assembly fixture for mounting the interconnected solar cells on a backplane.

In certain embodiments, the backplane is composed of polyester, polyimide, aramid, pyralux, or a poly (4,4'-oxydiphenylene-pyromellitimide) material.

In certain embodiments, the backplane is a mesh or flexible perforated carrier structure. See, e.g., U.S. Patent Application 12/362,225 filed January 29, 2009, published as U.S. Patent Publication 20100186804.

In certain embodiments, there further comprises automatically transferring the interconnected solar cells mounted on a backplane to a third assembly fixture for mounting the backplane on an aluminum honeycomb support structure or a printed circuit board.

In certain embodiments, there further comprises automatically transferring the interconnected solar cells mounted on a backplane to a fourth assembly fixture for mounting a coverglass over the solar cells.

In certain embodiments, the coverglass is a ceria doped borosilicate glass.

In certain embodiments, the fourth assembly fixture provides an adhesive layer between the solar cells and the coverglass selected from the group of: (i) a pressure sensitive adhesive (PSA) film; (ii) a hot-melt adhesive; or (iii) a silicone adhesive; which may be applied to the underside of the coverglass or the top surface of the solar cell.

In certain embodiments, there further comprises automatically transferring the interconnected solar cells with a coverglass mounted on a backplane to a fifth assembly fixture for assembling the solar cells into an array on a panel and bussing the solar cells into an electrical circuit using conductive ribbons or tabs.

In certain embodiments, the automatic transferring of the solar cells from the first to the second, third, fourth and fifth assembly fixtures are performed by roller tables or conveyors using machine vision alignment to fiducial markers.

In certain embodiments, there further comprises a method of automatically fabricating a rectangular array of series connected solar cells comprising: fabricating a first linear string of series-interconnected solar cells, the first string having a first end and opposite second end; automatically positioning the first string of series-interconnected solar cells on a first position on an assembly fixture; subsequently fabricating a second linear string of series-interconnected solar cells; the second string having a first end and an opposite second end; automatically positioning the second string of series-interconnected solar cells on a second position on the assembly fixture so that the first and second string are arranged parallel and directly adjacent to each other; electrically interconnecting the second end of the first string with the second end of the second string so that the first and second strings are connected in a series electrical circuit; and repeating the above steps to produce a rectangular array.

In another embodiment, the present disclosure provides a method of fabricating a multijunction solar cell array on a carrier using one or more automated processes, the method comprising: providing a first multijunction solar cell including a first contact pad and a second contact pad disposed adjacent the top surface of the multijunction solar cell along a first peripheral edge thereof; attaching a first electrical interconnect to the first contact pad of said first multijunction solar cell; attaching a second electrical interconnect to the second contact pad of the first multijunction solar cell; positioning said first multijunction solar cell over an adhesive region of a permanent carrier using an automated machine/vision apparatus; mounting a cover glass over said first multijunction solar cell; and bonding said first multijunction solar cell to said adhesive region using pressure and/or heat.

In some embodiments of the disclosure, the support is a KAPTON^{®} layer, that is, a polymide film layer. KAPTON^{®} is a trademark of E.I. du Pont de Nemours and Company. The chemical name for KAPTON^{®} is poly (4,4'-oxydiphenylene-pyromellitimide). Other polymide film sheets or layers may also be used.

In some embodiments, the support has a thickness of between 25 and 100 microns, or between 1 mil (25.4 µm) and 4 mil (101.6 µm).

In some embodiments, the support has a thickness of between 10 and 25 microns.

In some embodiments, a metal layer is attached to the support layer in an adhesiveless manner, to limit outgassing when used in a space environment.

In some embodiments the support is mounted on a metallic honeycomb structure.

The substrate may be a rigid substrate, such as an aluminum honeycomb substrate with carbon composite face sheet, or it may be a flexible substrate, such as a polymide film.

In some embodiments, after making the bonding connection, at least two solar cell devices are automatically interconnected using a pick and place process for positioning the interconnectors, followed by automatic parallel gap welding.

In some embodiments, contact pads are established by an automatic metallic plating process.

In some embodiments at least two solar cell devices are automatically electrically connected, for example wire bonded together, with the at least two solar cell devices having co-planar front-side electrical contacts.

In another aspect, the present disclosure provides a method of fabricating a solar cell panel comprising: providing first and second solar cells each having at least first and second spaced apart electrical contacts of first polarity on the top or light-facing surface thereof, and a third electrical contact of a second polarity on the bottom surface thereof; automatically bonding a first end portion of a first electrical interconnect ribbon disposed on the interconnect fabrication ribbon to the first electrical contact on the first solar cell; and automatically bonding a second electrically conductive end portion of the first electrical interconnect to the third electrical contact of the second solar cell, thereby making a series electrical connection of the first solar cell with the second solar cell.

In another aspect, the present disclosure provides a method of fabricating a solar cell panel comprising: providing first and second solar cells each having at least a first electrical contact of first polarity and a spaced apart electrical contact of second polarity on the surface thereof; automatically bonding a first end portion of a first electrical interconnect ribbon disposed on the interconnect fabrication ribbon to the first electrical contact on the first solar cell; and automatically bonding a second electrically conductive end portion of the first electrical interconnect to the second electrical contact of the second solar cell, thereby making a series electrical connection of the first solar cell with the second solar cell.

In another aspect, the present disclosure provides a space vehicle and its method of fabrication comprising: a payload disposed on or within the space vehicle; and a power source for the payload, including an array of solar cell assemblies mounted on a panel, with at least one solar cell panel or solar cell assembly being of the type described herein.

Some implementations of the present disclosure may incorporate or implement fewer of the aspects and features noted in the foregoing summaries.

Additional aspects, advantages, and novel features of the present disclosure will become apparent to those skilled in the art from this disclosure, including the following detailed description as well as by practice of the disclosure. While the disclosure is described below with reference to preferred embodiments, it should be understood that the disclosure is not limited thereto. Those of ordinary skill in the art having access to the teachings herein will recognize additional applications, modifications and embodiments in other fields, which are within the scope of the disclosure as disclosed and claimed herein and with respect to which the disclosure could be of utility.

### BRIEF DESCRIPTION OF THE DRAWING

To complete the description and in order to provide for a better understanding of the disclosure, a set of drawings is provided. Said drawings form an integral part of the description and illustrate embodiments of the disclosure, which should not be interpreted as restricting the scope of the disclosure, but just as examples of how the disclosure can be carried out. The drawings comprise the following figures:
FIG. 1A is a perspective view of a solar cell used in fabrication of a solar array panel according to the present disclosure;
FIG. 1B is a top plan view of the solar cell of FIG. 1A;
FIG. 1C is a top plan view of another embodiment of a solar cell according to the present disclosure;
FIG. 1D is a top plan view of the solar cell of FIG. 1C during the next process step;
FIG. 1E is a cross-sectional view of the solar cell of FIG. 1D through the IE-IE plane shown in FIG. 1D,
FIG. 2A is a highly simplified cross-sectional view of the first stage of the panel assembly process according to the present disclosure as configured on a first assembly fixture;
FIG. 2B is a highly simplified cross-sectional view of the second stage of the panel assembly process according to the present disclosure as configured on a first assembly fixture during which a second interconnect element is supplied;
FIG. 2C is a highly simplified cross-sectional view of the third stage of the panel assembly process according to the present disclosure as configured on a first assembly fixture in which the second interconnect element is positioned on the surface of the first assembly fixture;
FIG. 2D is a highly simplified cross-sectional view of the fourth stage of the panel assembly process according to the present disclosure as configured on a first assembly fixture during which a second solar cell is supplied and positioned over the top surface of the ribbon;
FIG. 3A is a highly simplified top plan view of the first stage of the panel assembly process according to the present disclosure as configured on a first assembly fixture;
FIG. 3B is a highly simplified cross-sectional view of the second stage of the panel assembly process according to the present disclosure as configured on a first assembly fixture during which two second interconnect ribbons are supplied;
FIG. 3C is a highly simplified cross-sectional view of the third stage of the panel assembly process according to the present disclosure as configured on a first assembly fixture in which the third solar cell is supplied;
FIG. 3D is a highly simplified cross-sectional view of the fourth stage of the panel assembly process according to the present disclosure as configured on a first assembly fixture during which a pair of third interconnect ribbons are supplied corresponding to the cross-sectional view of FIG. 2D;
FIG. 4 is a highly simplified perspective view of the interconnect elements being arranged along the top and bottom surfaces of three solar cells during the assembly process depicted in FIGS. 2 and 3, thereby making a serial electrical connection between the solar cells;
FIG. 5A is a highly simplified top plan view of four interconnect elements being arranged and bonded to contacts along the edges of the top surface of the set of four unifacial solar cells during the assembly process in a parallel configuration;
FIG. 5B is a highly simplified top plan view of four interconnect elements being arranged and bonded to contacts along the edges of the top surface of a set of four unifacial solar cells during the assembly process in a parallel configuration;
FIG. 6 is a highly simplified top plan view of three solar cells being arranged along the top surface of a carrier during the assembly process according to one embodiment of the present disclosure;
FIG. 7 is a highly simplified diagrammatic representation of one embodiment for the interconnection of individual modules or subassemblies as building blocks of a panel configuration;
FIG. 8 is an exploded view of a panel configuration including a mechanical supporting structure and a printed circuit board;
FIG. 9 is a cross-sectional view of a laser welding process;
FIG. 10 is a flowchart representing an assembly method in accordance with an embodiment of the present disclosure;
FIG. 11 is a depiction of an assembly line for producing solar cell panels according to the present disclosure;
FIG. 12 is a highly simplified exploded view of a solar cell panel according to one embodiment of the present disclosure depicting an array of coverglass mounted over the array of strings of solar cells;
FIG. 13 is a perspective view of a cross section of an interconnect ribbon depicting a polyimide ribbon or carrier with an internal metal interconnect extending along the length of the ribbon;
FIG. 14 is a perspective view of a metallic honeycomb structure which can be used for mounting a support;
FIG. 15 is a cross-sectional view of an aluminum honeycomb substrate with carbon composite face sheet; and
FIG. 16 is a cross-sectional view of an aluminum honeycomb substrate with carbon composite face sheet and a co-cured polyimide substrate.

### DESCRIPTION OF ILLUSTRATIVE EMBODIMENTS

Details of the present invention will now be described including exemplary aspects and embodiments thereof. Referring to the drawings and the following description, like reference numbers are used to identify like or functionally similar elements, and are intended to illustrate major features of exemplary embodiments in a highly simplified diagrammatic manner. Moreover, the drawings are not intended to depict every feature of the actual embodiment nor the relative dimensions of the depicted elements, and are not drawn to scale.

Although this disclosure is not limited to the use of multijunction solar cells, the handling of such solar cells in an automated process presents unique processing challenges, and accordingly a variety of different features of multijunction solar cells are disclosed in the related applications noted above. Some, many, or all of such features may be included in the structures and processes associated with the solar cells arrays, assemblies, and panels of the present disclosure. However, more particularly, the present disclosure is directed to the handling and transport of solar cells in an automated process for assembling the solar cells into a panel, including the design and mounting of the interconnect element between adjacent solar cells, and automated processes for stringing the solar cells into an array and into the final panel configuration.

In certain embodiments of the present disclosure, one or more of the method steps may be performed using an automated process. Exemplary automated processes for some of the steps are further discussed herein below. However, the present disclosure is intended to include alternative automated processes that are known in the art for each method step. Further, the exemplary automated processes discussed herein to carry out one method step may be used to carry out other method steps not explicitly discussed herein. In some embodiments a plurality of recited method steps may be performed using one or more automated processes. In certain embodiments, all of the recited method steps may be performed using one or more automated processes.

In some embodiments, the automated process may use a robot (e.g., pick and place assembly tools) to perform a conventional manual process.

In some embodiments, a wire bonding laser welding machine can be used for attaching interconnects to one or more solar cells.

In some embodiments, the one or more automated processes may use machine vision. Machine vision can include imaging-based automatic inspection and analysis for applications such as automatic inspection, process control, and robot guidance. Although conventional (2D visible light) imaging is most commonly used in machine vision, alternatives include imaging various infrared bands, line scan imaging, 3D imaging of surfaces, and X-ray imaging. The most commonly used method for 3D imaging is scanning based triangulation which utilizes motion of the product or image during the imaging process. Other 3D methods used for machine vision are time of flight, grid based, and stereoscopic.

For machine vision, the imaging device (e.g. camera) can either be separate from the main image processing unit or combined with it in which case the combination can be a smart camera or a smart sensor. When separated, the connection may be made to specialized intermediate hardware such as a frame grabber using either a standardized or custom interface. Machine vision can also use digital cameras capable of direct connections (without a framegrabber) to a computer.

Although the vast majority of machine vision applications use two-dimensional imaging, machine vision applications utilizing 3D imaging are a growing alternative. One method is grid array based systems using pseudorandom structured light system. Another method of generating a 3D image is to use laser triangulation, where a laser is projected onto the surfaces of an object and the deviation of the line is used to calculate the shape. In machine vision this is accomplished with a scanning motion, either by moving the workpiece, or by moving the camera and laser imaging system. Stereoscopic vision can be used in special cases involving unique features present in both views of a pair of cameras.

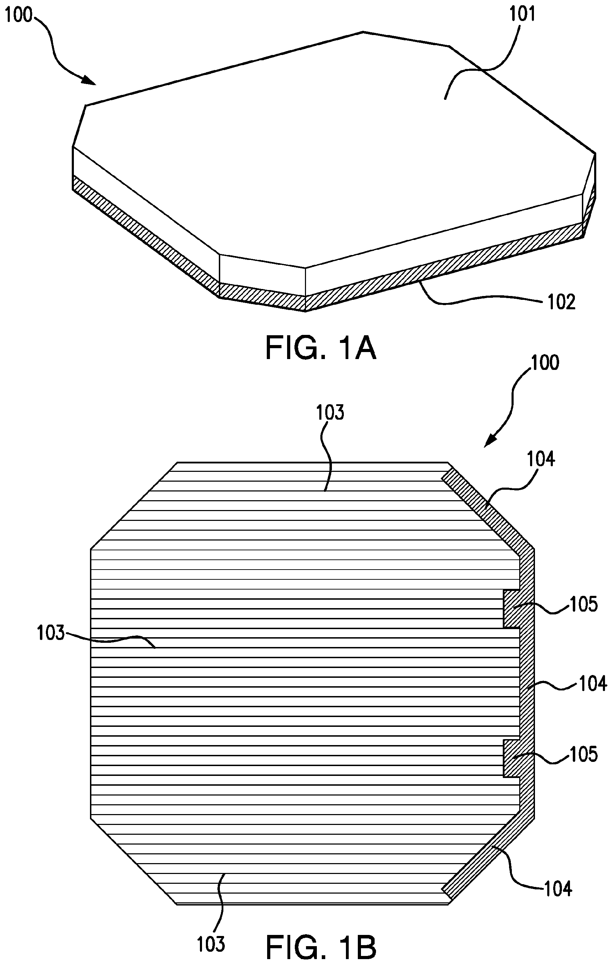

FIG. 1A is a perspective view of a solar cell 100 used in fabrication of a solar array panel according to the present disclosure. The solar cell 100 includes a semiconductor body 101 and back metal 102, which constitutes an electrical contact of one polarity.

FIG. 1B is a top plan view of one embodiment of the solar cell of FIG. 1A depicting grid lines 103, a bus bar 104 located on one edge of the solar cell 100, and two contact pads 105 integrally formed with the bus bar 104.

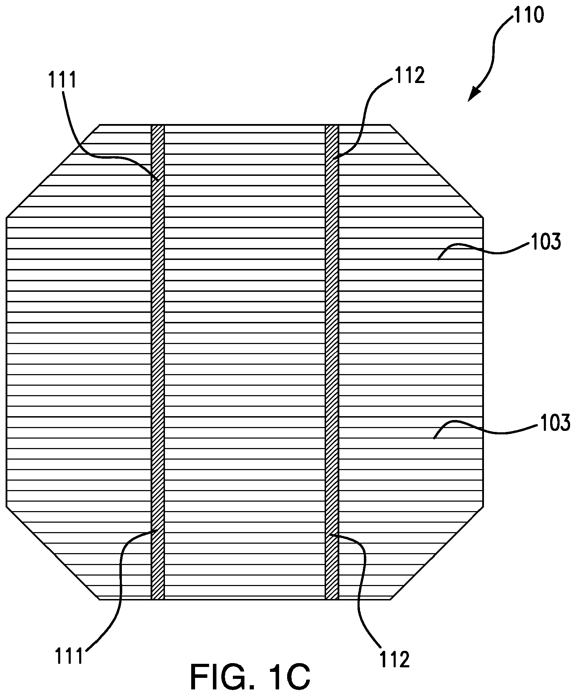

FIG. 1C is a top plan view of another embodiment of a solar cell 110 according to the present disclosure which has two parallel bus bars 111 and 112 electrically connected to the grid lines 103, the two bus bars dividing the solar cell into three portions.

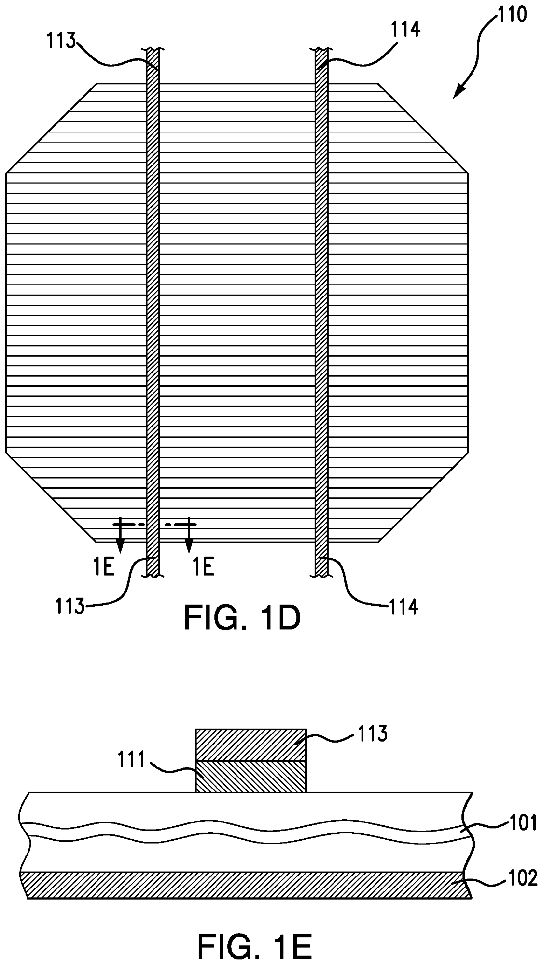

FIG. 1D is a top plan view of the solar cell of FIG. 1C during the next process step in which interconnection elements or ribbons 113 and 114 are automatically positioned over bus bars 111 and 112 respectively.

FIG. 1E is a cross-sectional view of the solar cell of FIG. 1D through the 1E-1E plane shown in FIG. 1D, depicting the electrical interconnection of a metallic portion of the ribbon 113 with the bus bar 111.

The automated assembly method involves placing interconnects that will connect the contact pad(s) of one cell to the contacts of an adjacent cell in a fashion that places them in electrical series or parallel, as required by the voltage-current needs of the intended application. The method involves application of interconnects, in the form of conductive tabs of shapes and sizes suitable for interconnection of the solar cells, across the contact pads, then fixing those interconnects in place on the contacts utilizing various methods to form metallurgical joints including soldering, welding, brazing, ultrasonic bonding, or the application of a conductive adhesive, as applicable based on the materials employed, in order to effect the electrical connections.

The apparatus involves a dispenser of interconnects and a method to place them correctly and form the required electrical connections or joints. In one embodiment, this may be a roll or reel of a conductive material (e.g. silver ribbon or wire) that is dispensed or pulled to or across a solar cell's contact pads, after which the interconnects are fixed in place with a joint between the interconnect and the solar cell's contract pad(s). Alternatively, the interconnects may be singular pieces of wires, ribbons, foils or related that are placed by the apparatus, either bringing the cell into contact with the interconnect or the interconnect into contact with the cell in order to achieve the same physical configuration suitable for forming the joints. The apparatus accomplishes the alignment of the parts by fixturing or by software-defined spatial coordinates or by machine vision or by some combination of these methods.

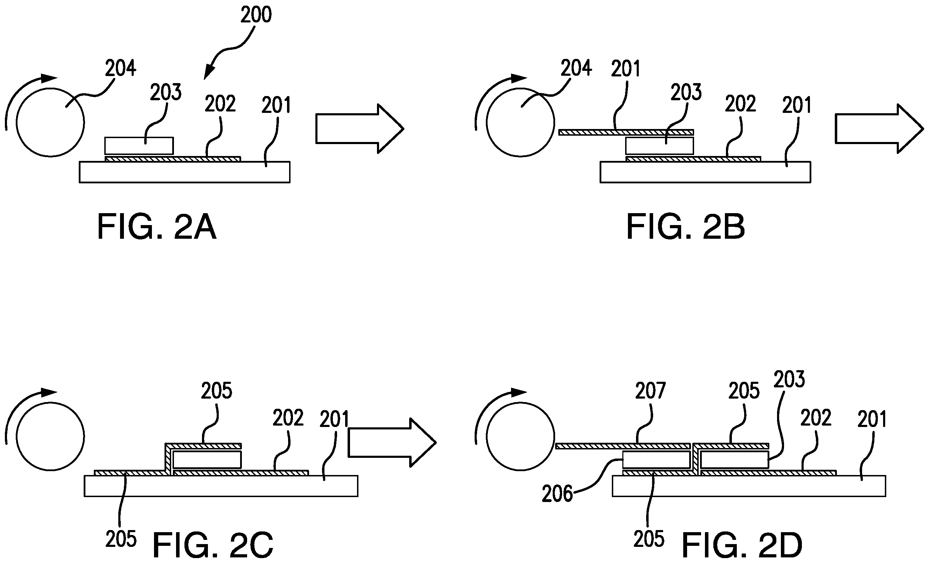

Figure 2 (comprising FIGS. 2A through 2E) depicts an arrangement of bifacial cells in electrical series. An apparatus provides conductive interconnection material, after which the apparatus places the solar cell such that the cell's contact pad(s) are in alignment and contact with the interconnect and fixes it in place with a joint. The process is repeated with a second interconnect, it being dispensed or placed in contact with (an)other contact pad(s) of the solar cell and a joint made, followed again by placement of another solar cell, and so on.

An electrical interconnection is then made between the back metal 102 (as depicted in FIG. 1A) of the solar cell 203 and the metal surface of the ribbon 202, using any of the methods described above.

FIG. 2A is a highly simplified cross-sectional view of the first stage of the panel assembly process according to one embodiment of the present disclosure as configured on a first assembly fixture 201. In this representation, an interconnect element or ribbon 202 having a predetermined length is provided by a supply reel 204, represented in a highly simplified manner, and automatically moved into position on the surface of the assembly fixture 201. Subsequently, a first solar cell 203 automatically positioned over a portion of the ribbon 202.

FIG. 2B is a highly simplified cross-sectional view of the second stage of the panel assembly process according to the present disclosure as configured on a first assembly fixture 201 during which a second interconnect element 205 is supplied by supply reel 204.

An electrical interconnection is then made between the bus bars 111 and 112 (as depicted in FIG. 1C) of the solar cell 203 and the bottom metal surface of the ribbon 205, using any of the methods described above.

FIG. 2C is a highly simplified cross-sectional view of the third stage of the panel assembly process according to the present disclosure as configured on a first assembly fixture 201 in which the second interconnect element 205 is positioned on the surface of the first assembly fixture 201 so as to be able to connect with the bottom surface of the next solar cell to be supplied to the fixture.

FIG. 2D is a highly simplified cross-sectional view of the fourth stage of the panel assembly process according to the present disclosure as configured on a first assembly fixture 201 during which a second solar cell 206 is supplied (by a supply cassette, not shown) and positioned over the top surface of the ribbon 205.

In the fifth stage of the panel assembly process according to the present disclosure as configured on a first assembly fixture, a third interconnect element 207 is supplied by supply reel 204 to make electrical contact with the bus bars 111 and 112 of solar cell 206.

An electrical interconnection is then made between the bus bars 111 and 112 (as depicted in FIG. 1C) of the solar cell 206 and the bottom metal surface of the ribbon 207, using any of the methods described above.

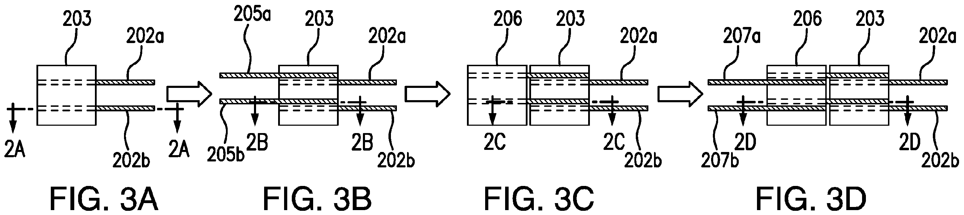

FIG. 3A is a highly simplified top plan view of the first stage of the panel assembly process according to the present disclosure as configured on a first assembly fixture 201 corresponding to the cross-sectional view of FIG. 2A. The top view of the solar cell 203 is depicted with two interconnect ribbons 202a and 202b extending on the top of the assembly fixture 201 and the solar cell 203 mounted over portions of the ribbons 202a and 202b. FIG. 3B is a highly simplified cross-sectional view of the second stage of the panel assembly process according to the present disclosure as configured on a first assembly fixture 201 during which two second interconnect ribbons 205a and 205b are supplied making contact with bus bars on the top surface of the solar cell 203; corresponding to the cross-sectional view of FIG. 2B.

FIG. 3C is a highly simplified cross-sectional view of the third stage of the panel assembly process according to the present disclosure as configured on a first assembly fixture 201 in which the third solar cell 206 is supplied, the bottom surface thereof making electrical contact with the interconnect ribbons 205a and 205b. The second interconnect ribbons 205a and 205b are positioned corresponding to the cross-sectional view of FIG. 2D.

FIG. 3D is a highly simplified cross-sectional view of the fourth stage of the panel assembly process according to the present disclosure as configured on a first assembly fixture 201 during which a pair of third interconnect ribbons 207a and 207b are supplied corresponding to the cross-sectional view of FIG 2D.

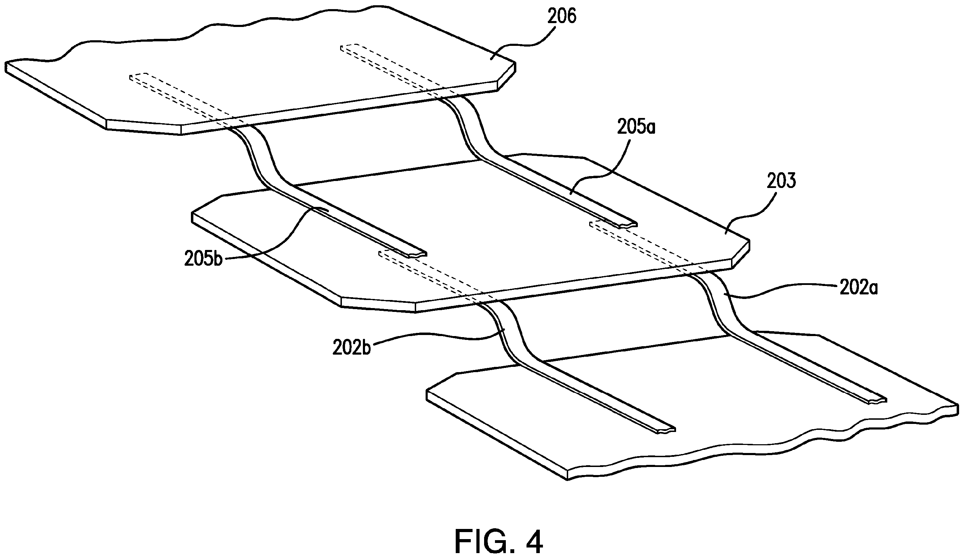

FIG. 4 is a highly simplified perspective view of the interconnect elements 202a, 202b, 205a and 205b being arranged along the top and bottom surfaces of three solar cells 206, 203, and 190 during the assembly process depicted in FIGS. 2 and 3, thereby making a serial electrical connection between the solar cells.

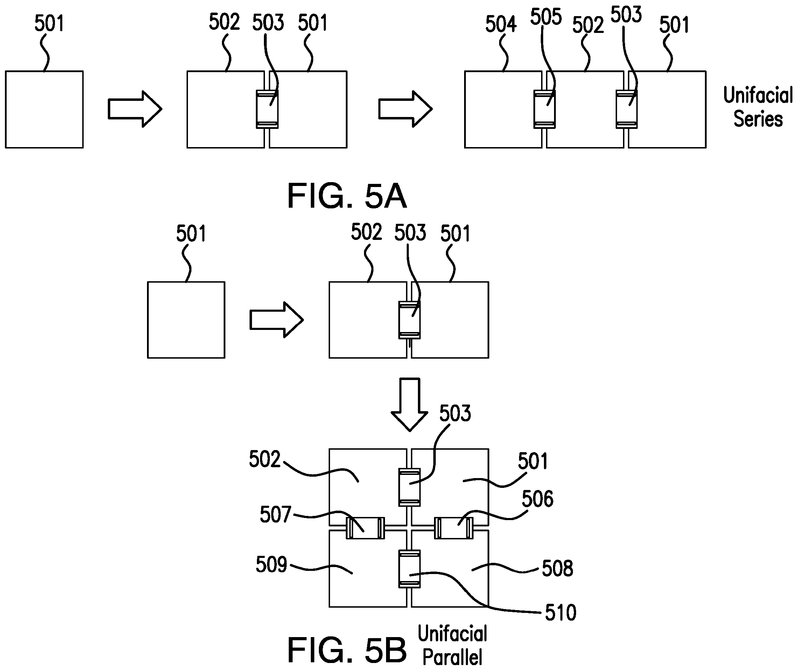

FIGS. 5A and 5B depict arrangements of unifacial cells in electrical series and parallel. An apparatus places solar cells with one or more contact pads on the cells' top or bottom or top and bottom surfaces, with the contact pads providing access to the two electric poles of the p-n junction, then applies and appropriately aligns by robotic automation an interconnect material before fixing it in place with a joint. The orientation of the solar cells' contact pads with the p-n junctions and of the solar cells to one another can produce various series-parallel arrangements to achieve certain current-voltage characteristics.

An arrangement of bifacial cells in electrical parallel can also be implemented. An apparatus provides conductive interconnection material, after which the apparatus places the solar cell such that the cell's contact pad(s) are in alignment and contact with the interconnect and fixes it in place with a joint. A second cell is placed adjacent to the first and aligned and fixed with a joint in the same manner, and so on. The process is repeated with interconnects being dispensed and placed in contact with (an)other contact pad(s) of the solar cells and a joint made, and so on.

In a further embodiment, strings, circuits, arrays and/or sub-assemblies thereof may be used as building blocks, just as individual solar cells were in FIG. 2, 3 and 5, to assemble more complex arrays. In this way, complex arrays or circuits can be built up from standard solar cells of any technology so as to meet any certain current-voltage requirement. Arrays in electrical series and/or parallel can be further assembled in electrical series and/or parallel to "grow" interchangeable repeat units into specific configurations so as to meet any certain current-voltage requirement.

In other embodiments, unifacial parallel arrays may be assembled in series or parallel. An apparatus places assembled strings, circuits or sub-assemblies thereof, appropriately aligning them to one another, then introduces an interconnect material and fixes it in place with a joint. The orientation of the solar cells' or arrays' contact pads with the p-n junctions and of the solar cells to one another can be chosen and arranged produce various series-parallel arrangements to achieve certain current-voltage characteristics.

The assembled string, circuit, array or sub-assembly thereof is then transferred via an automated apparatus to a carrier or backplane. In some embodiments, that carrier or backplane may serve only as a carrier to enable automated apparatus or robot to transport or further fabricate the solar power module or SPM. In other embodiments that carrier or backplane may become part of the completed panel and may serve some mechanical, structural and/or electrical function in the SPM or higher level assembly. The apparatus provides the carrier or backplane, by introducing it from a dispenser (for example, a reel or roll from which sheets are cut) or from an inventory (for example, from a stack of glass superstrates or PCB backplanes).

The backplane or carrier may be prepared for bonding to strings, circuits, arrays or sub-components thereof by an apparatus that introduces an adhesive layer in between the solar cells and the backplane. That adhesive layer may be a pressure-sensitive film adhesive (PSA), a so-called hot melt adhesive, or a silicone adhesive, including room temperature vulcanizing (RTV) silicone, or a conductive adhesive. The adhesive may be introduced in an automated process that applies the film to or dispenses the uncured adhesive onto the backplane or carrier or onto the solar cell front or back side.

In some methods, the cells, string, circuit or sub-components may be automatically assembled face up - i.e., backplane, then adhesive, then cell assembly. In some methods, the cells, string, circuit or sub-component thereof may be automatically assembled face down - i.e., carrier, then adhesive, then cell assembly.

In one embodiment, assembly is "face down", i.e. the assembly of strings, circuits or sub-assemblies is assembled "face down" on a carrier (coverglass).

In another embodiment, the assembly is "face up", i.e., the face up assembly of strings, circuits or sub-assemblies is assembled "face up" on a backplane.

In embodiments in which strings, circuits or sub-components thereof are bonded onto a carrier (top, sun-facing coverglass), a backplane may or may not be incorporated by addition of an adhesive layer and then the backplane material onto the subcomponents.

In some embodiments, the backplane may be Kapton, some other form of polyimide or some other similar lightweight, flexible and electrically insulating material that provides adequate support and meets the required stability and reliability requirements of a particular application. In some embodiments, the backplane may incorporate metallized areas that cause it to serve as a type of printed circuit board that will participate in the interconnection of cells and/or other electrical components of the SPM or in the transmission of electrical power generated by the solar cells back to the load being powered in the application. In some embodiments, the carrier may be glass, fiberglass (such as FR4) or some other adequate support that meets the stability and reliability requirements of a particular application.

FIG. 5A is a highly simplified top plan view of two interconnect elements 503 and 505 being arranged and bonded to contacts of opposite polarity disposed along the edges of the top surfaces of a set of three unifacial solar cells 501, 502, and 504 during one assembly process according to the present disclosure.

FIG. 5B is a highly simplified top plan view of four interconnect elements 503, 506, 507 and 510 being arranged and bonded to contacts along the edges of the top surface of a set of four unifacial solar cells 501, 502, 508 and 509 during the assembly process in a parallel configuration.

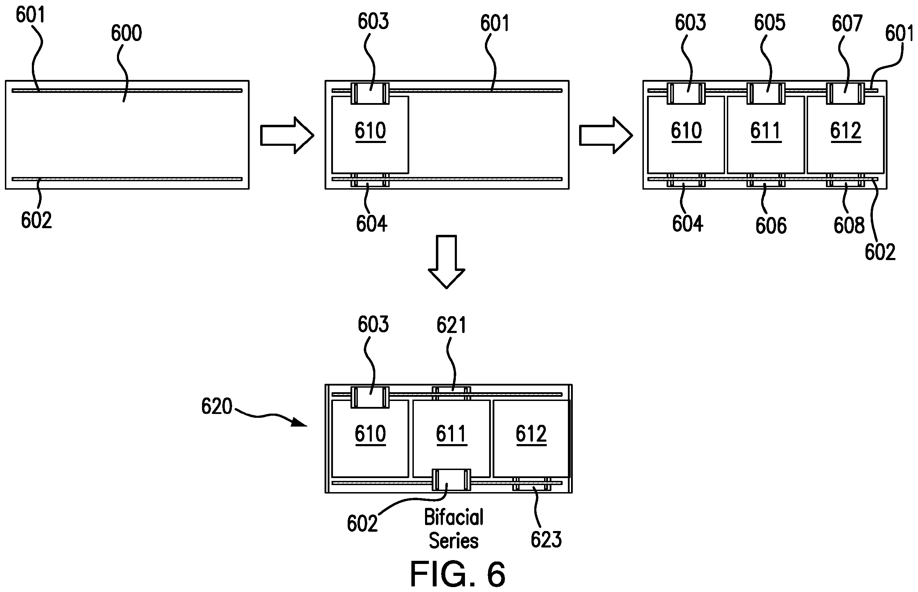

FIG. 6 is a highly simplified top plan view of three solar cells 610, 620, 630 being arranged along the top surface of a carrier 600 during the assembly process according to one embodiment of the present disclosure.

FIG. 6 depicts an assembly onto backplane or carrier in which an apparatus places assembled string, circuit, array or sub-assembly thereof onto a carrier or backplane that may serve only as a carrier to enable automated apparatus or robot to transport or further fabricate the SPM or that may become part of the completed panel and may serve some mechanical, structural and/or electrical function in the SPM or higher level assembly. Shown also: proof of concept apparatus for transferring arrays onto backplanes.

Backplane- or Carrier-mediated assembly. An apparatus places solar cells with one or more contact pads on the cells' top or bottom or top and bottom surfaces onto a carrier that itself incorporates contact pads on the its top or bottom or top and bottom surfaces with required alignment, then further applies and appropriately aligns by robotic automation an interconnect material before fixing it in place with a joint. The orientation of the solar cells' contact pads with the p-n junctions and of the solar cells to one another and of the solar cells to the contact pads on the carrier produce various series-parallel arrangements to achieve certain current-voltage characteristics.

As strings, circuits, arrays and/or sub-assemblies thereof mounted onto backplanes may also be used as building blocks, just as individual solar cells were done in order to assemble more complex arrays. In this way, complex arrays or circuits can be built up from standard solar cells and arrays of any technology so as to meet any certain current-voltage requirement. Arrays in electrical series and/or parallel can be further assembled in electrical series and/or parallel to "grow" interchangeable repeat units into specific configurations so as to meet any certain current-voltage requirement.

Interconnections or joints can be made between arrays on backplanes by either interconnecting the individual units (i.e. solar cells) or the PCB backplanes in electrical series and/or parallel so as to meet any certain current-voltage requirement.

In some embodiments, the backplane may be capable of being integrated onto a rigid solar array substrate, such as an aluminum-honeycomb panel with a carbon composite facesheet. In other embodiments, the backplane may be capable of being integrated onto flexible solar array structures like the synthetic fiber or fiberglass mesh structures incorporated into the UltraFlex Solar Array System of Northrop Grumman of Goleta, California or the Roll-Out Solar Array (ROSA) of Deployable Space Systems, Inc. of Santa Barbara, California. In some embodiments, the backplane may be a coverglass that forms the front (sun-facing) surface of the panel, against which the strings are assembled face or top during fabrication.

All embodiments require bussing of strings, circuits or sub-components thereof to aggregate series or parallel connections in order to supply a desired current-voltage profile from the panel. Bussing is accomplished through the introduction of electrical interconnections to the terminations of strings, circuits or sub-components thereof that connect those units into electrical series or parallel with other units. Bussing may be performed manually or by automated apparatus that interconnect the strings, circuits, arrays or sub-components utilizing various methods including soldering, welding, brazing or ultrasonic bonding in order to form a metallurgical joint. Bussing may utilize electrical interconnections introduced to the manufacturing process in the form of ribbons or tabs. Alternative, bussing may utilize metallization incorporated onto or into the backplane, for example, if the backplane is a type of printed circuit board.

Embodiments on a backplane may require a front, sun-facing glass for encapsulation or protection of the strings, circuits or sub-assemblies from physical damage, on-orbit radiation, UV exposure or other potential damaging elements on the ground or on orbit. The cover may take the form of a single unit that covers the entire string, circuit or sub-assembly, as shown in the figure below, left. Alternatively, the cover may be applied to only a portion of the string, circuit or sub-assembly, including as little as one cell in an embodiment in which each cell is covered individually by its own superstrate, as shown in the figure below, right. The cover in every embodiment may be introduced by an automated apparatus that picks up the glass, aligns it and places it on the cell using programmable x,y locations, machine vision alignment to fiducial markers or a related pattern recognition methodology.

The cover(s) may be a smooth or may be textured, formed or patterned to manipulate incoming light by focusing, dispersing, directing or filtering the light. The cover(s) may be bare or may incorporate one or more coatings that improve transmission, filter or reflect selected wavelengths or otherwise to manipulate incoming light incident on the panel.

The cover(s) may be prepared for bonding to solar strings, circuits, arrays or sub-assemblies by introducing an adhesive layer in between the solar cells and the cover(s). That adhesive layer may be a pressure-sensitive film adhesive (PSA), a so-called hot melt adhesive, or a silicone adhesive. The adhesive may be introduced in an automated process that applies the film to or dispenses the uncured adhesive onto the underside of the cover or onto the solar cell front side.

Each of the automated assembly processes described above can be standalone operations, or can be joined by automated transfer of the cells, strings, circuits or sub-assemblies from station to station using roller tables, conveyors or similar means of transfer.

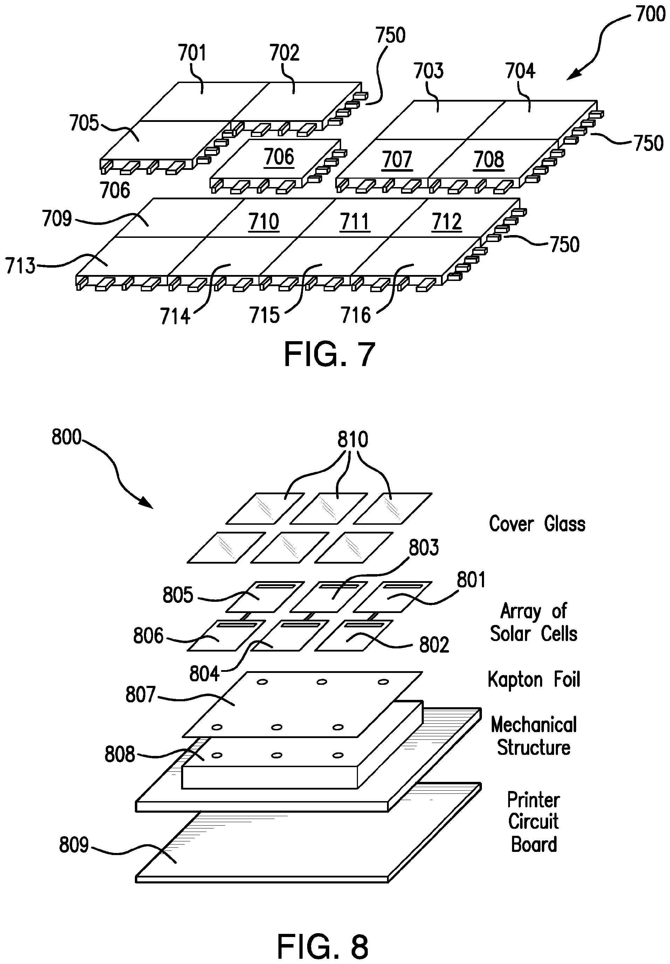

FIG. 7 is a highly simplified diagrammatic representation of one embodiment for the interconnection of individual modules or subassemblies 701, 702, ... 715, 716 as building blocks of a panel configuration. Multiple edge connectors 750 are illustrated to indicate how adjacent modules may be plugged together to form an array with any desired aspect ratios and allow each module to be connected in serial or parallel with adjacent modules.

FIG. 8 is an exploded view of a panel configuration including a mechanical supporting structure 808 and a printed circuit board 809. In this embodiment, individual cover glasses 810 are provided over each solar cell 801, 802, ... 806. The solar cells are mounted and bonded to a Kapton foil 807, which in turn is mounted on the mechanical structure 808, which in turn is mounted on a printed circuit board 809.

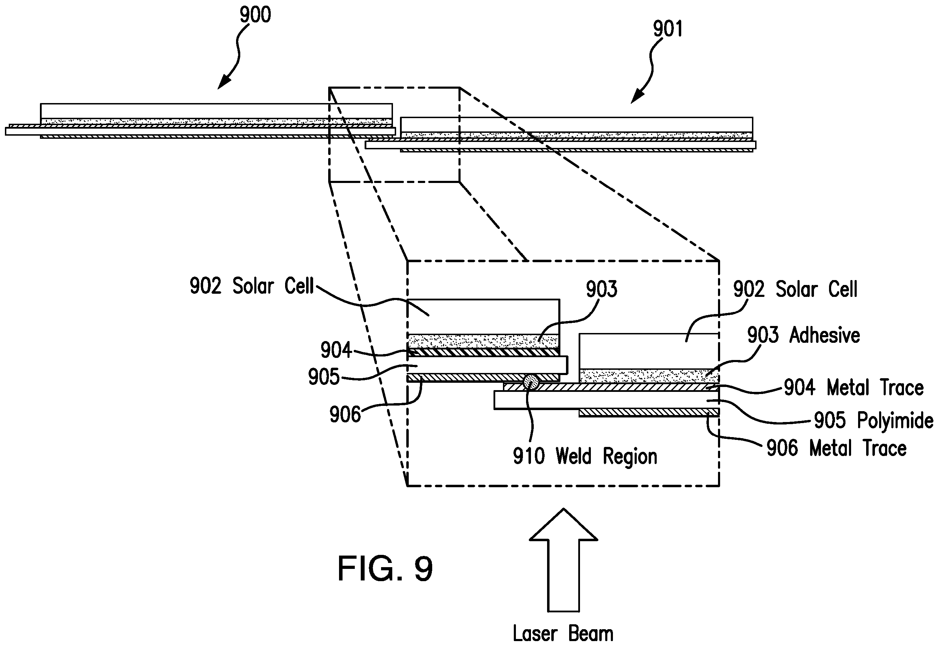

FIG. 9 is a cross-sectional view of a laser welding process. The current industry standard method for interconnecting solar cell assemblies, or "CICs", involves the use of rigid metallic tabs that are joined using resistance welding. This technique involves applying pressure and creating heat via the flow of current through a weld head, through the solar cell weld pad, and back up another weld head located adjacent and parallel to the first weld head, hence the term "parallel gap" welding. Welding is the joining and interconnection technique of choice for space solar arrays due to the avoidance of solder or electrical adhesives that have perceived reliability problems. However, resistance welding is not necessarily well suited to the joining of thin semiconductor devices and results in a narrow process window. Furthermore, rigid metallic interconnects, where their ability to accommodate strain or flex is determined completely by the stress relief features built into their design, are not necessarily compatible with ultra-thin solar cells (one example being IMM) or with flexible arrays due to their inherent rigidity.

In U.S. patent 6,919,529, there is described a process for using a laser welder to join discrete components to a flexible circuit, and from the opposite side of a polyimide flex circuit, thereby illuminating the weld joint through the mostly transparent polyimide film. Polyimide is mostly transparent to the 1064 nm laser wavelength emitted from Nd:YAG lasers, which are a common source for laser welding tools. From the teachings of this patent, it is suggested that not only could laser welding be used for solar cell applications, but that the polyimide backing that supports the thin metal traces to be welded could be left intact, resulting in an inherently mechanically sound structure post-weld.

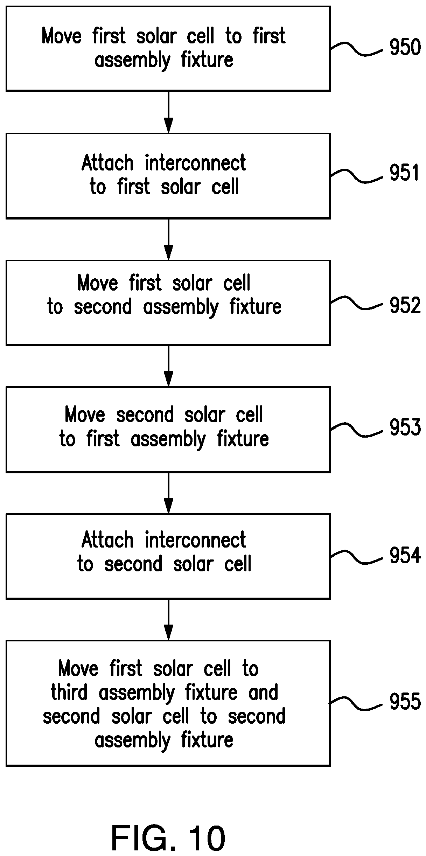

FIG. 10 is a flowchart representing a method in accordance with an embodiment of the present disclosure. In step 950, move the first solar cell to the first assembly fixture. In step 951, attach the interconnect to the first solar cell. In step 952, move the first solar cell to the second assembly fixture. In step 953, move the second solar cell to the first assembly fixture. In step 954, attach an interconnect to the second solar cell. In step 955, move the first solar cell to the third assembly fixture and the second solar cell to the second assembly fixture.

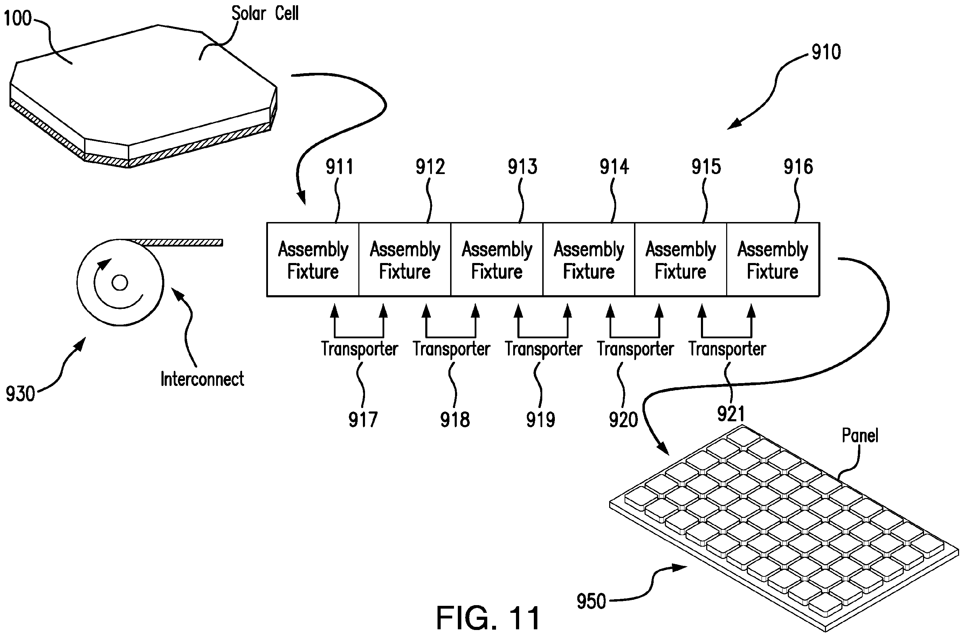

FIG. 11 is a depiction of an assembly line 910 for producing solar cell panels 950 according to the present disclosure. A sequence of solar cells 100 are supplied in an automated manner to a first assembly fixture 911 (such as represented in FIGS. 2A through 2D above) where it is positioned to receive an interconnect element 202, which is bonded to an electrical contact on the solar cell 100 as described in connection with FIGS. 2A through 2D.

A transporter 917 can then move the assembled string of solar cells (203, 206,... etc.) to a second assembly fixture 912 where the string of solar cells may be mounted on a carrier 600 such as depicted in FIG. 6. Electrical connection can then be made to the bus bars 601, 602 on the carrier 600. In one embodiment, such carrier may be the Kapton foil 8107 shown in FIG. 8.

Following mounting on a carrier (such as 600 depicted in FIG. 6) the string of solar cells (e.g., 610, 611, 612) with the carrier may be transported to one or more additional fixtures or work stations where further assembly and test operations may be performed. These may include:
(i) mounting and electrical connection of a blocking diode on the panel;
(ii) mounting and electrical connection of additional electronic components;
(iii) mounting and electrical connection of terminals, wiring, and/or mechanical stand-offs or interface components;
(iv) mounting of cover glass over each individual solar cell or group of solar cells; and
(v) testing the assembled panel according to a sequence of testing protocols.

There are substantially more rigorous qualification and acceptance testing protocols used in the manufacture of space solar cells compared to terrestrial cells to ensure that space solar cells can operate satisfactorily at the wide range of temperatures and temperature cycles encountered in space. Examples of testing the assembled panel noted in (v) above are testing protocols that may include (i) high-temperature thermal vacuum bake-out; (ii) thermal cycling in vacuum (TVAC) or ambient pressure nitrogen atmosphere (APTC); and in some applications (iii) exposure to radiation equivalent to that which would be experienced in the space mission, and measuring the current and voltage produced by the cell and deriving cell performance data.

As used in this disclosure and claims, the term "space-qualified" shall mean that the electronic component (i.e., the solar cell) provides satisfactory operation under the high temperature and thermal cycling test protocols. The exemplary conditions for vacuum bake-out testing include exposure to a temperature of +100 °C to +135 °C (e.g., about +100 °C, +110 °C, +120 °C, +125 °C, +135 °C) for 2 hours to 24 hours, 48 hours, 72 hours, or 96 hours; and exemplary conditions for TVAC and/or APTC testing that include cycling between temperature extremes of -180 °C (e.g., about -180 °C, -175 °C, -170 °C, -165 °C, - 150 °C, -140 °C, -128 °C, -110 °C, -100 °C, -75 °C, or -70 °C) to +145 °C (e.g., about +70 °C, +80 °C, +90 °C, +100 °C, +110 °C, +120 °C, +130 °C, +135 °C, or +145 °C) for 600 to 32,000 cycles (e.g., about 600, 700, 1500, 2000, 4000, 5000, 7500, 22000, 25000, or 32000 cycles), and in some space missions up to +180° C. See, for example, Fatemi et al., "Qualification and Production of Emcore ZTJ Solar Panels for Space Missions," Photovoltaic Specialists Conference (PVSC), 2013 IEEE 39th (DOI: 10. 1109/PVSC 2013 6745052).

Conventionally, such measurements are made for the AM0 spectrum for "one-sun" illumination, but for PV systems which use optical concentration elements, such measurements may be made under concentrations such as 2x, 100x, or 1000x or more.

The transport of the carriers may be performed automatically by conveyors or other mechanical means from the second assembly fixture 912, to third, fourth, fifth and sixth assembly fixtures 913, 914, 915, and 916 respectively, in which one or more of the assembly operations (i) through (v) noted above may take place.

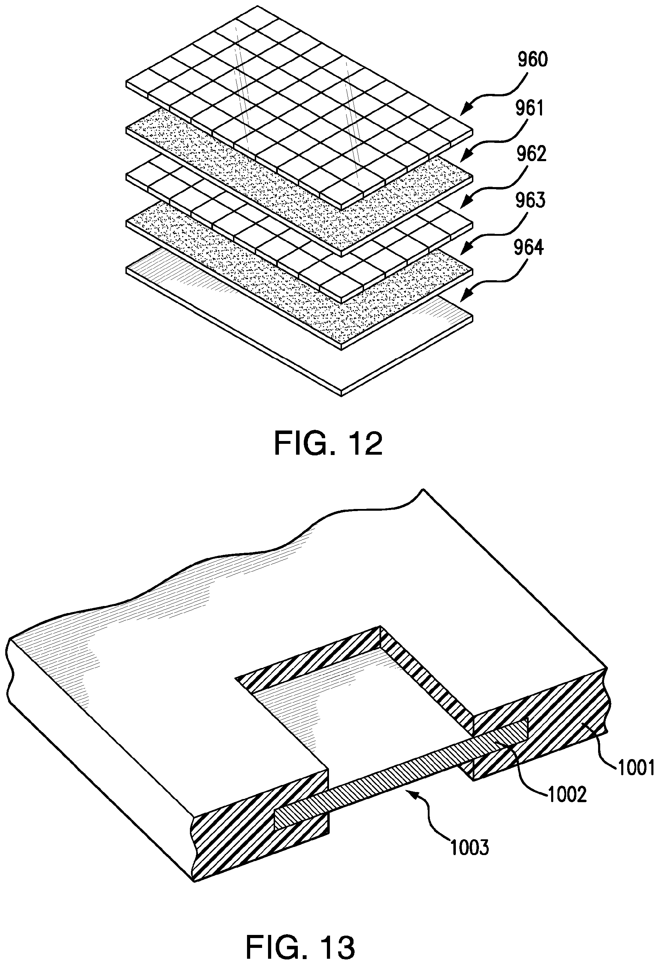

FIG. 12 is a highly simplified exploded view of a solar cell panel according to one embodiment of the present disclosure depicting an array of cover glasses 960 mounted over an adhesive layer 961, which in turn is mounted over the array of strings of solar cells 962. The array of strings of solar cells is mounted to a support or carrier 964 by an adhesive layer 963.

FIG. 13 is a perspective view of a cross section of an interconnect ribbon 1000, depicting a polyimide ribbon or carrier 1001, with an internal metal interconnect 1002 extending along the length of the ribbon 1000. The metal may be silver, a silver alloy, or a nickel-iron alloy or similar metal. A gap or aperture 1003 is provided in the center region of the ribbon 1000 along a discrete region thereon where electrical contact to terminals on the solar cell may be made.

Solar cell wafers can be prepared by automated methods of depositing III-V compound semiconductor layers and other layers (e.g., antireflective coating. ARC) on a substrate to fabricate a wafer. Such methods that are readily amenable to automation include, for example, metal organic chemical vapor deposition (MOCVD) methods that are readily known in the art. Backside metallization of a cell can be performed, for example, by evaporation or electrodeposition on a polyimide layer (e.g., a KAPTON^{®} layer).

Features such as grid lines and mesas can be formed on the front sides of the wafers using conventional techniques such as lithography, metal deposition, and etching techniques, all of which are readily amenable to automation using, for example, machine vision.

Solar cell configurations particularly suitable for assembly using automated processes include those that are described in U.S. Patent Application No. 14/592,519, filed January 8, 2015; 14/719,911, filed May 21, 2015; 14/729.412, filed June 3, 2015; and 14/729,422, filed June 3, 2015.

One or more solar cells can be formed from a wafer using conventional techniques such as dicing or scribing. The size and shape of the solar cells can be varied as desired for particular applications as disclosed, for example, in U.S. Patent Application No. 14/592,519, filed January 8, 2015. Dicing or scribing of solar cells from a wafer as well as the assembly of the individual pieces into a mosaic composite or arrangement of pieces into a geometric structure such as a square or rectangle is particularly amenable to automation using machine vision.23

The functionality of the one or more solar cells can be tested by conventional automated testing equipment.

Interconnects can be attached to the one of more solar cells using, for example, automatic soldering or laser welding equipment.

In some embodiments, one end of the interconnects can have parallel gap apertures, and the interconnects can be connected, for example, by applying a parallel gap welding tool.

In some embodiments, all electrical components in the solar cell array can be continuously encapsulated with CV grade silicone, which can be used to mount multi-cell large area coverglass, or as a surface for applying advanced coatings such as Cover Glass Replacement (CGR) or radiation resistant coatings. This approach can produce an array that is electrically isolated, can mitigate high voltage arcing problems, can eliminate cracks and seams to minimize the need for expensive inter-cell grouting, and can enable electrostatic cleanliness.

Dispensing of silicone onto solar cells and coverglass has typically been performed using a patterned silk screening process or squeegee approaches. These processes require additional materials and process associated with designing and producing templates, as well as the wasteful nature of hand mixing and application. These processes are inherently wasteful and laborious, driving high cost and low process throughput. The approach described herein provides for the simple low cost and high precision application of silicone adhesive to solar cell assemblies with standardized carriers.

In some embodiments, a silicone can be dispensed on the solar cell using, for example, an automated Asymtek machine with visual recognition for maximum precision.

A cover glass can be attached to each solar cell to form a Cell-Interconnect-Cover Glass (CIC) using automated methods. For example, in some embodiments the CIC assembly process can be completed with the implementation of automated assembly and lamination. After large area or precision dispensing operations have been performed, a temporary carrier can be fixtured in a component placement machine. Using computerized visual recognition of fiducial location points, a numerically controlled component placement machine can pick the large area solar cell coverglass from a cartridge stack, placing this upon the uncured silicone dispensed in the previous step, which can then be cured to form the CIC.

In some embodiments, a similar component placement step can be implemented to both load a wire-bonding machine, as well as to perform the final submodule placement onto any suitable number of solar array substrates such as a flexible membrane or a rigid composite sandwich panel. Such automated methods can reduce or eliminate labor intensive hand operations from the entire process.

CICs can be positioned and placed on a support in an automated manner, for example, by a pick and place assembly tool to form a string configuration of CICs as described, for example, in U.S. Patent Application Nos. 14/719,911, filed May 21, 2015, and 14/729,412, filed June 3, 2015. Bypass and blocking diodes can be configured by similar methods.

Solar cells in a string can be interconnected using, for example, standard automation equipment for wire bonding such as an automated thermosonic wire-bonding machine, and also as disclosed, for example, in U.S. Patent Application No. 14/719,911, filed May 21, 2015.

String configurations or interconnected string configurations of solar cells positioned and placed on a support in an automated manner, for example, by a pick and place assembly tool as described, for example, in U.S. Patent Application Nos. 14/719,911, filed May 21, 2015, and 14/729,412, filed June 3, 2015. In certain embodiments, the string configurations or interconnected string configurations of solar cells can be bonded to the substrate by the automatic application of pressure and/or heat and interconnected in a similar manner as discussed herein above.

Configuring and wiring a panel circuit and terminal can be performed using conventional automated wiring equipment.

Testing the functionality of the solar cell panel can be performed by automated methods similar to those discussed herein above for testing of individual solar cells. For example, 5-cell submodules have been fabricated using the processes described herein. Testing on the submodules performed included electrical continuity, grounding, and isolation testing. The submodules were subjected them to thermal cycling from -120 °C to +120 °C to represent typical LEO orbital conditions; from -180 °C to +80 °C to represent typical GEO orbital conditions; and in a related program, to plasma environments at high voltage, as an initial qualification to Low Earth Orbit environments. All tests showed good performance and reliability for the solar cell strings before and after exposure to these environments.

An engineering economic analysis of the benefits of the automated bonding and assembly processes was performed to quantify the benefits to lowering the cost of solar cell strings sub-modular building blocks. The data in Table 1 which is reproduced from the parent patent application demonstrates substantial array integration cost reduction. The results, summarized in Table 1, are on a comparative basis only and do not necessarily represent a particular absolute price for a photovoltaic array or panel in a particular quantity. Labor estimates were made based on fully burdened labor rates including a postulated overhead, but do not account for potential alternative manufacturing cell and team structures. Labor rates also do not account for the lower skill level labor that could be implemented with automated assembly equipment compared to the higher level of skill that is often required for manual fixtured or semi-automated assembly.

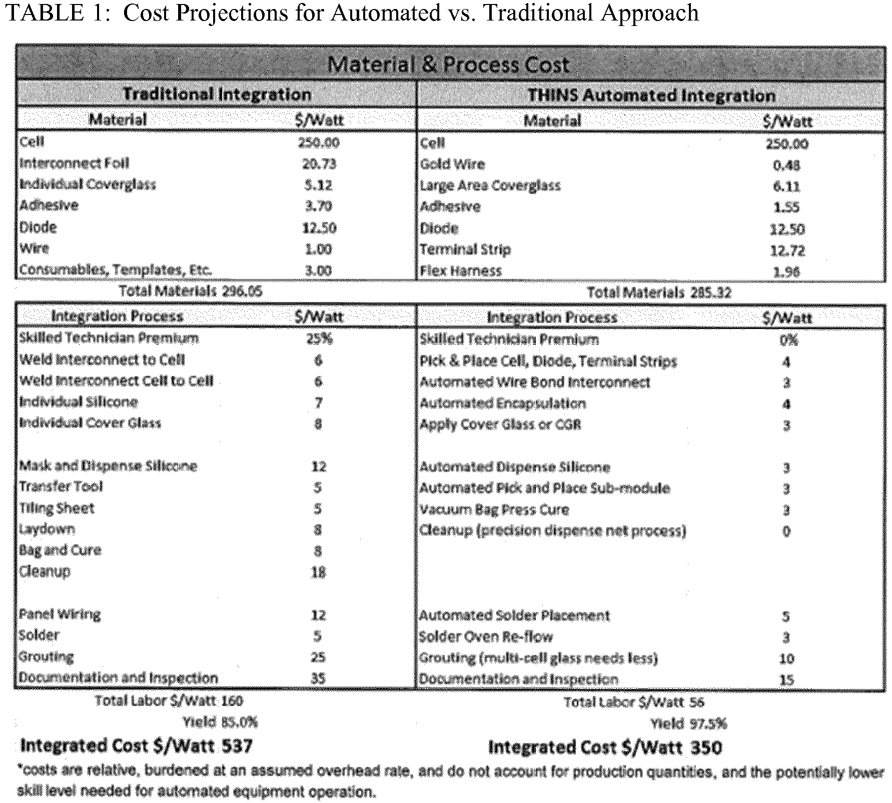

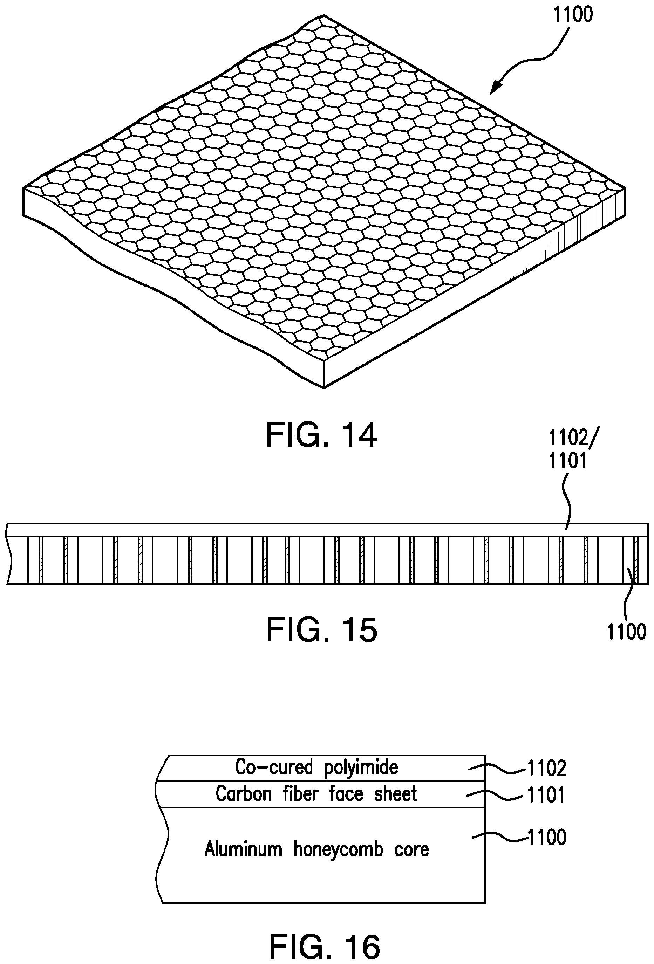

FIG. 14 is a perspective view of a metallic honeycomb structure 1100 which can be used for mounting a support, flexible film, or platform on which the solar cells are mounted and interconnected.

FIG. 15 is a cross-sectional view of an aluminum honeycomb substrate 1100 including a carbon composite face sheet 1101/1102 attached thereto. In some embodiments, a double sided adhesive film can be positioned on the top surface of the face sheet, and the bottom surface of the adhesive film can be bonded to the top surface of the face sheet by, for example, co-curing. In some embodiments, a plurality of layers of carbon composite sheets can be embedded in a matrix of cyanate ester adhesive. The polyimide flexible film supporting the solar cells can then be put on top of the carbon composite face sheet and the whole stack co-cured.

In some embodiments, a sequence of solar cell assemblies can be positioned over the top surface of the adhesive film, and each of the sequence of solar cell assemblies can be sequentially bonded to a predefined region on the top surface of the adhesive film, for example, by automatic application of pressure and/or heat. In some embodiments, the predefined region contains a pressure sensitive adhesive, and no adhesive is present on other regions of the top surface of the face sheet.

FIG. 16 is a cross-sectional view of an aluminum honeycomb substrate 1100 with carbon composite face sheet 1101 attached to aluminum honeycomb substrate 1100, and co-cured polyimide substrate 1102 attached to carbon composite face sheet 1101.

It is to be noted that the terms "front", "back", "top", "bottom", "over", "on", "under", and the like in the description and in the claims, if any, are used for descriptive purposes and not necessarily for describing permanent relative positions. It is understood that the terms so used are interchangeable under appropriate circumstances such that the embodiments of the disclosure described herein are, for example, capable of operation in other orientations than those illustrated or otherwise described herein.

Furthermore, those skilled in the art will recognize that boundaries between the above described operations are merely illustrative. The multiple units/operations may be combined into a single unit/operation, a single unit/operation may be distributed in additional units/operations, and units/operations may be operated at least partially overlapping in time. Moreover, alternative embodiments may include multiple instances of a particular unit/operation, and the order of operations may be altered in various other embodiments.

In the claims, the word 'comprising' or 'having' does not exclude the presence of other elements or steps than those listed in a claims. The terms "a" or "an", as used herein, are defined as one or more than one. Also, the use of introductory phrases such as "at least one" and "one or more" in the claims should not be construed to imply that the introduction of another claim element by the indefinite articles "a" or "an" limits any particular claim containing such introduced claim element to disclosures containing only one such element, even when the claim includes the introductory phrases "one or more" or "at least one" and indefinite articles such as "a" or "an". The same holds true for the use of definite articles. Unless stated otherwise, terms such as "first" and "second" are used to arbitrarily distinguish between the elements such terms describe. Thus, these terms are not necessarily intended to indicate temporal or other prioritization of such elements. The fact that certain measures are recited in mutually different claims does not indicate that a combination of these measures cannot be used to advantage.

The present disclosure can be embodied in various ways. The above described orders of the steps for the methods are only intended to be illustrative, and the steps of the methods of the present disclosure are not limited to the above specifically described orders unless otherwise specifically stated. Note that the embodiments of the present disclosure can be freely combined with each other without departing from the scope of the disclosure.

Although some specific embodiments of the present disclosure have been demonstrated in detail with examples, it should be understood by a person skilled in the art that the above examples are only intended to be illustrative but not to limit the scope of the present disclosure. It should be understood that the above embodiments can be modified without departing from the scope of the present disclosure which are to be defined by the attached claims.

## Claims

1. A method of fabricating a space solar array panel comprising:
providing first and second solar cells (203, 206) each having at least first and second spaced apart electrical contacts of first polarity on the top or light-facing surface thereof, and a third electrical contact of a second polarity on the bottom surface thereof;
automatically positioning the first solar cell (203) to a first position with the bottom surface of the first solar cell (203) positioned on a first assembly fixture (201);
automatically positioning a first electrically conductive end portion of an electrical interconnect fabrication ribbon (205) over the first solar cell (203) positioned on the first assembly fixture (201);
automatically bonding a first end portion of a first electrical interconnect ribbon (205) disposed on the interconnect fabrication ribbon to the first electrical contact on the first solar cell (203);
moving the first solar cell (203) to a second position adjacent to the first position on the first assembly fixture (201);
positioning a second solar cell (206) adjacent to the first solar cell (203) on the first assembly fixture (201) over the interconnect fabrication ribbon (205); and
bonding a second electrically conductive end portion of the first electrical interconnect ribbon (205) to the third electrical contact of the second solar cell (206), thereby making a series electrical connection of the first solar cell (203) with the second solar cell (206),
wherein the first and second electrical contacts on the top surface of each solar cell (203, 206) comprise at least two parallel equally spaced apart strips forming first and second bus bars extending from one edge of each solar cell (203, 206) to the opposite edge, and
wherein positioning the first electrically conductive end portion of the electrical interconnect fabrication ribbon (205) over the first solar cell (203) positioned on the first assembly fixture (201) includes positioning a first interconnect fabrication ribbon (205a) over one of the parallel contact strips, and positioning a second interconnect fabrication ribbon (205b) automatically over the second of the parallel contact strips, and the first and second interconnect fabrication ribbons (205a, 205b) are automatically bonded to the first and second parallel contact strips by ultrasonic or parallel gap welding, and the second portion of the electrical interconnect fabrication ribbon (205) is bonded to the third electrical contact of the second solar cell (206) by ultrasonic or parallel gap welding.

2. The method as defined in claim 1, wherein each solar cell (203, 206) is selected from the group consisting of
i) single junction, polycrystalline or monocrystalline silicon, hetero- or homo-junction; or
ii) GaAs-based single junction, to include variants that contain small amounts of indium InₓGa₁₋ₓAs 0<x<1, in order to adjust bandgap, lattice parameter or spectral responsivity; or
iii) GaAs-based dual junction, to include variants that contain small amounts of indium InₓGa₁₋ₓP on InₓGa₁₋ₓAs 0<x<1, and/or small amounts of aluminum AlₓIn_{y}Ga_{1-x-y}P on AlₓIn_{y}Ga_{1-x-y}As 0<x<1, 0<y<1, in order to adjust bandgap, lattice parameter or spectral responsivity; or
iv) germanium-based dual junction, to include variants that contain small amounts of indium InₓGa₁₋ₓP on InₓGa₁₋ₓAs 0<x<1, and or small amounts of aluminum AlₓIn_{y}Ga_{1-x-y}P on AlₓIn_{y}Ga_{1-x-y}As 0<x<1, 0<y<1, in order to adjust bandgap, lattice parameter or spectral responsivity; or
v) germanium-based triple junction, four junction, or five junction solar cells.

3. The method as defined in any of the preceding claims, wherein the electrical interconnect fabrication ribbon (205) is composed of a silver material, and the third electrical contact on the bottom surface of each solar cell (203, 206) is a metal layer including gold and/or silver covering a portion of or the entire backside surface of each solar cell (203, 206).

4. The method as defined in claim 1, further comprising:
automatically moving the first solar cell (203) to a third position adjacent to the second position on the assembly fixture (201); and simultaneously moving the second solar cell (206) to the second position adjacent to the first position on the assembly fixture (201);
positioning a third solar cell adjacent to the second solar cell (206) on the assembly fixture and repeating the process of automatically positioning a third portion of an interconnect fabrication ribbon (205) over the third solar cell positioned on the first assembly fixture (201); and
automatically bonding the third portion of a second electrical interconnect disposed on the interconnect fabrication ribbon (205) to the first electrical contact on the third solar cell.

5. A method as defined in claim 4, wherein the interconnect fabrication ribbon (205) extending between the second portion and the third portion is conductive so that the first, second, and third solar cells (203, 206) are connected in an electrical series.

6. A method as defined in any of the preceding claims, further comprising automatically transferring the series interconnected solar cells to a second assembly fixture for mounting the interconnected solar cells on a backplane, which is composed of polyester, polyimide, aramid, pyralux, or a poly 4,4'-oxydiphenylene-pyromellitimide material, and/or a mesh or perforated structure.

7. A method as defined in claim 6, further comprising automatically transferring the interconnected solar cells mounted on a backplane to a third assembly fixture for mounting the backplane on an aluminum honeycomb support structure or a printed circuit board.

8. A method as defined in claim 7, further comprising automatically transferring the interconnected solar cells mounted on a backplane to a fourth assembly fixture for mounting a coverglass over the solar cells, wherein the coverglass is a ceria doped borosilicate glass.

9. A method as defined in claim 8, wherein the fourth assembly fixture provides an adhesive layer between the solar cells and the coverglass selected from the group of :
i) a pressure sensitive adhesive, PSA, film;
ii) a hot-melt adhesive; or
iii) a silicone adhesive;
which may be applied to the underside of the coverglass or the top surface of the solar cell.

10. A method as defined in claim 9, further comprising automatically transferring the interconnected solar cells with a coverglass mounted on a backplane to a fifth assembly fixture for assembling the solar cells into an array on a panel and bussing the solar cells into an electrical circuit using conductive ribbons or tabs.

11. A method as defined in claim 10, wherein the automatic transferring of the solar cells from the first to the second, third, fourth and fifth assembly fixtures are performed by roller tables or conveyors using machine vision alignment to fiducial markers.

12. A method as defined in any of the preceding claims, further comprising a first linear string of series-interconnected solar cells from the serially connected at least first and second solar cells to form the first string having a first end and an opposite second end;
automatically positioning the first string of series-interconnected solar cells on a first position on an assembly fixture;
subsequently fabricating a second linear string of series-interconnected solar cells; the second string having a first end and an opposite second end;
automatically positioning the second string of series-interconnected solar cells on a second position on the assembly fixture so that the first and second string are arranged parallel and directly adjacent to each other;
electrically interconnecting the second end of the first string with the second end of the second string so that the first and second strings are connected in a series electrical circuit; and
repeating the above steps to produce a rectangular array.

## Patentansprüche

1. Verfahren zum Fertigen eines Weltraum-Solarzellenflächenmoduls, umfassend:
Bereitstellen einer ersten und einer zweiten Solarzelle (203, 206), die jeweils mindestens einen ersten und einen zweiten elektrischen Kontakt erster Polarität, die voneinander beabstandet sind, auf der oberen oder dem Licht zugewandten Oberfläche derselben und einen dritten elektrischen Kontakt einer zweiten Polarität auf der unteren Oberfläche derselben aufweisen;
automatisches Positionieren der ersten Solarzelle (203) in eine erste Position, in der die untere Oberfläche der ersten Solarzelle (203) auf einer ersten Montagevorrichtung (201) positioniert ist;36
automatisches Positionieren eines ersten elektrisch leitfähigen Endabschnitts eines elektrischen Verbindungs-Fertigungsbands (205) über der auf der ersten Montagevorrichtung (201) positionierten ersten Solarzelle (203);
automatisches Fügen eines auf dem Verbindungs-Fertigungsband angeordneten ersten Endabschnitts eines ersten elektrischen Verbindungsbands (205) an den ersten elektrischen Kontakt auf der ersten Solarzelle (203);
Bewegen der ersten Solarzelle (203) in eine der ersten Position benachbarte zweite Position auf der ersten Montagevorrichtung (201);
Positionieren einer zweiten Solarzelle (206) der ersten Solarzelle (203) benachbart auf der ersten Montagevorrichtung (201) über dem Verbindungs-Fertigungsband (205); und
Fügen eines zweiten elektrisch leitfähigen Endabschnitts des ersten elektrischen Verbindungsbands (205) an den dritten elektrischen Kontakt der zweiten Solarzelle (206), wodurch eine elektrische Reihenschaltung der ersten Solarzelle (203) mit der zweiten Solarzelle (206) hergestellt wird,
wobei der erste und der zweite elektrische Kontakt auf der oberen Oberfläche jeder Solarzelle (203, 206) mindestens zwei parallele, gleichmäßig beabstandete Streifen umfassen, die eine erste und eine zweite Sammelschiene bilden, die sich von einem Rand jeder Solarzelle (203, 206) zu dem gegenüberliegenden Rand erstrecken, und
wobei das Positionieren des ersten elektrisch leitfähigen Endabschnitts des elektrischen Verbindungs-Fertigungsbands (205) über der auf der ersten Montagevorrichtung (201) positionierten ersten Solarzelle (203) das Positionieren eines ersten Verbindungs-Fertigungsbands (205a) über einem der parallelen Kontaktstreifen und das automatische Positionieren eines zweiten Verbindungs-Fertigungsbands (205b) über dem zweiten der parallelen Kontaktstreifen umfasst und das erste und das zweite Verbindungs-Fertigungsband (205a, 205b) durch Ultraschall- oder Parallelspaltschweißen automatisch an den ersten und den zweiten parallelen Kontaktstreifen gefügt werden und der zweite Abschnitt des elektrischen Verbindungs-Fertigungsbands (205) durch Ultraschall- oder Parallelspaltschweißen an den dritten elektrischen Kontakt der zweiten Solarzelle (206) gefügt wird.

2. Verfahren nach Anspruch 1, wobei die Solarzellen (203, 206) jeweils aus der Gruppe ausgewählt werden, die aus Solarzellen folgender Art besteht:
i) aus polykristallinem oder monokristallinem Silizium mit einem einzigen Hetero- oder einem einzigen Homoübergang; oder
ii) GaAs-basiert mit einem einzigen Übergang, einschließlich Varianten, die kleine Mengen Indium InₓGa₁₋ₓAs 0<x<1 enthalten, um Bandlücke, Gitterparameter oder spektrale Empfindlichkeit anzupassen; oder
iii) GaAs-basiert mit zwei Übergängen, einschließlich Varianten, die kleine Mengen Indium InₓGa₁₋ₓP auf InₓGa₁₋ₓAs 0<x<1 und/oder kleine Mengen Aluminium AlₓIn_{y}Ga_{1-x-y}P auf AlₓIn_{y}Ga_{1-x-y}As 0<x<1, 0<y<1 enthalten, um Bandlücke, Gitterparameter oder spektrale Empfindlichkeit anzupassen; oder
iv) Germanium-basiert mit zwei Übergängen, einschließlich Varianten, die kleine Mengen Indium InₓGa₁₋ₓP auf InₓGa₁₋ₓAs 0<x<1 und/oder kleine Mengen Aluminium AlₓIn_{y}Ga_{1-x-y}P auf AlₓIn_{y}Ga_{1-x-y}As 0<x<1, 0<y<1 enthalten, um Bandlücke, Gitterparameter oder spektrale Empfindlichkeit anzupassen; oder
v) Germanium-basiert mit drei Übergängen, vier Übergängen oder fünf Übergängen.

3. Verfahren nach einem der vorangehenden Ansprüche, wobei das elektrische Verbindungs-Fertigungsband (205) aus einem Silbermaterial hergestellt ist und der dritte elektrische Kontakt auf der unteren Oberfläche jeder Solarzelle (203, 206) eine Gold und/oder Silber umfassende Metallschicht ist, die die gesamte rückseitige Oberfläche oder einen Abschnitt davon jeder Solarzelle (203, 206) abdeckt.

4. Verfahren nach Anspruch 1, ferner umfassend:
automatisches Bewegen der ersten Solarzelle (203) in eine der zweiten Position benachbarte dritte Position auf der Montagevorrichtung (201); und gleichzeitiges Bewegen der zweiten Solarzelle (206) in die der ersten Position benachbarte zweite Position auf der Montagevorrichtung (201);
Positionieren einer dritten Solarzelle der zweiten Solarzelle (206) benachbart auf der Montagevorrichtung und Wiederholen des Prozesses des automatischen Positionierens eines dritten Abschnitts eines Verbindungs-Fertigungsbands (205) über der auf der ersten Montagevorrichtung (201) positionierten dritten Solarzelle; und
automatisches Fügen des auf dem Verbindungs-Fertigungsband (205) angeordneten dritten Abschnitts einer zweiten elektrischen Verbindung an den ersten elektrischen Kontakt auf der dritten Solarzelle.

5. Verfahren nach Anspruch 4, wobei das sich zwischen dem zweiten Abschnitt und dem dritten Abschnitt erstreckende Verbindungs-Fertigungsband (205) leitfähig ist, sodass die erste, die zweite und die dritte Solarzelle (203, 206) elektrisch in Reihe geschaltet werden.

6. Verfahren nach einem der vorangehenden Ansprüche, ferner umfassend das automatische Umsetzen der in Reihe geschalteten Solarzellen auf eine zweite Montagevorrichtung zum Anbringen der miteinander verbundenen Solarzellen auf eine Rückplatte, die aus Polyester, Polyimid, Aramid, Pyralux oder einem Poly 4,4'-Oxydiphenylen-Pyromellitimid-Material und/oder einer Netz- oder Lochstruktur hergestellt ist.

7. Verfahren nach Anspruch 6, ferner umfassend das automatische Umsetzen der auf einer Rückplatte angebrachten miteinander verbundenen Solarzellen auf eine dritte Montagevorrichtung zum Anbringen der Rückplatte auf einer Aluminiumwaben-Tragstruktur oder einer Leiterplatte.

8. Verfahren nach Anspruch 7, ferner umfassend das automatische Umsetzen der auf einer Rückplatte angebrachten miteinander verbundenen Solarzellen auf eine vierte Montagevorrichtung zum Anbringen eines Deckglases über den Solarzellen, wobei das Deckglas ein Cer-dotiertes Borosilikatglas ist.

9. Verfahren nach Anspruch 8, wobei die vierte Montagevorrichtung eine Klebeschicht zwischen den Solarzellen und dem Deckglas bereitstellt, die aus folgender Gruppe ausgewählt ist:
i) einem Haftklebstoff-PSA-Film;
ii) einem Schmelzklebstoff; oder
iii) einem Silikonklebstoff;
der auf die Unterseite des Deckglases oder die obere Oberfläche der Solarzelle aufgebracht werden kann.

10. Verfahren nach Anspruch 9, ferner umfassend das automatische Umsetzen der auf einer Rückplatte angebrachten miteinander verbundenen Solarzellen mit einem Deckglas auf eine fünfte Montagevorrichtung zum Montieren der Solarzellen zu einer Solarzellenfläche auf einem Modul und Verbinden der Solarzellen zu einem elektrischen Stromkreis durch einen Bus unter Verwendung leitfähiger Bänder oder Laschen.

11. Verfahren nach Anspruch 10, wobei das automatische Umsetzen der Solarzellen von der ersten auf die zweite, die dritte, die vierte und die fünfte Montagevorrichtung durch Rollentische oder Förderer ausgeführt wird, die maschinelle Sichtausrichtung auf Referenzmarkierungen verwenden.

12. Verfahren nach einem der vorangehenden Ansprüche, ferner umfassend eine erste lineare Kette von in Reihe geschalteten Solarzellen aus der in Reihe geschalteten mindestens ersten und zweiten Solarzelle, um die erste Kette zu bilden, die ein erstes Ende und ein entgegengesetztes zweites Ende aufweist;
automatisches Positionieren der ersten Kette von in Reihe geschalteten Solarzellen in eine erste Position auf einer Montagevorrichtung;
anschließendes Fertigen einer zweiten linearen Kette von in Reihe geschalteten Solarzellen, wobei die zweite Kette ein erstes Ende und ein entgegengesetztes zweites Ende aufweist;
automatisches Positionieren der zweiten Kette von in Reihe geschalteten Solarzellen in eine zweite Position auf der Montagevorrichtung, sodass die erste und die zweite Kette parallel und einander direkt benachbart angeordnet werden;
elektrisches Verbinden des zweiten Endes der ersten Kette mit dem zweiten Ende der zweiten Kette, sodass die erste und die zweite Kette in einer elektrischen Reihenschaltung verbunden sind; und
Wiederholen der vorangehenden Schritte, um eine rechteckige Fläche zu erzeugen.

## Revendications

1. Procédé de fabrication d'un panneau pour réseau solaire spatial comprenant les étapes consistant à :
fournir des première et deuxième cellules solaires (203, 206) chacune ayant au moins des premier et deuxième contacts électriques espacés l'un de l'autre d'une première polarité sur sa surface supérieure ou qui fait face à la lumière, et un troisième contact électrique d'une seconde polarité sur sa surface inférieure ;
positionner automatiquement la première cellule solaire (203) vers une première position avec la surface inférieure de la première cellule solaire (203) positionnée sur un premier appareil d'assemblage (201) ;
positionner automatiquement une première partie d'extrémité électriquement conductrice d'un ruban de fabrication d'interconnexion électrique (205) sur la première cellule solaire (203) positionnée sur le premier appareil d'assemblage (201) ;
lier automatiquement une première partie d'extrémité d'un premier ruban d'interconnexion électrique (205) disposée sur le ruban de fabrication d'interconnexion vers le premier contact électrique sur la première cellule solaire (203) ;
déplacer la première cellule solaire (203) vers une deuxième position adjacente à la première position sur le premier appareil d'assemblage (201) ;
positionner une deuxième cellule solaire (206) adjacente à la première cellule solaire (203) sur le premier appareil d'assemblage (201) sur le ruban de fabrication d'interconnexion (205) ; et
lier une deuxième partie d'extrémité électriquement conductrice du premier ruban d'interconnexion électrique (205) au troisième contact électrique de la deuxième cellule solaire (206), réalisant ainsi une connexion électrique en série de la première cellule solaire (203) avec la deuxième cellule solaire (206),
les premier et deuxième contacts électriques sur la surface supérieure de chaque cellule solaire (203, 206) comprenant au moins deux bandes espacées également parallèles formant des première et deuxième barres omnibus s'étendant depuis un bord de chaque cellule solaire (203, 206) vers le bord opposé, et
le positionnement de la première partie d'extrémité électriquement conductrice du ruban de fabrication d'interconnexion électrique (205) sur la première cellule solaire (203) positionné sur le premier appareil d'assemblage (201) incluant le positionnement d'un premier ruban de fabrication d'interconnexion (205a) sur l'une des bandes de contact parallèles, et le positionnement d'un deuxième ruban de fabrication d'interconnexion (205b) automatiquement sur la deuxième des bandes de contact parallèles, et les premier et deuxième rubans de fabrication d'interconnexion (205a, 205b) sont automatiquement liés aux première et deuxième bandes de contact parallèles par soudage par ultrasons ou par capillarité parallèle, et la deuxième partie du ruban de fabrication d'interconnexion électrique (205) est liée au troisième contact électrique de la deuxième cellule solaire (206) par soudage par ultrasons ou par capillarité parallèle.

2. Procédé selon la revendication 1, dans lequel chaque cellule solaire (203, 206) est choisie dans le groupe constitué de cellules solaires
i) au silicium polycristallin ou monocristallin à jonction unique, hétéro ou homo-j onction ; ou
ii) à jonction unique à base de GaAs, pour inclure des variants qui contiennent de petites quantités d'indium InₓGa₁₋ₓAs 0 < x < 1, afin d'ajuster la bande interdite, le paramètre de maille ou l'efficacité spectrale ; ou
iii) à j onction double à base de GaAs, pour inclure des variants qui contiennent de petites quantités d'indium InₓGa₁₋ₓP sur InₓGa₁₋ₓAs 0 < x < 1, et/ou de petites quantités d'aluminium AlₓIn_{y}Ga_{1-x-y}P sur AlₓIn_{y}Ga_{1-x-y}As 0 < x < 1, 0 < y < 1, afin d'ajuster la bande interdite, le paramètre de maille ou l'efficacité spectrale ; ou
iv) à jonction double à base de germanium, pour inclure des variants qui contiennent de petites quantités d'indium InₓGa₁₋ₓP sur InₓGa₁₋ₓAs 0 < x < 1, et/ou de petites quantités d'aluminium AlₓIn_{y}Ga_{1-x-y}P sur AlₓIn_{y}Ga_{1-x-y}As 0 < x < 1, 0 < y < 1, afin d'ajuster la bande interdite, le paramètre de maille ou l'efficacité spectrale ; ou
v) à jonction triple, quadruple ou quintuple à base de germanium.

3. Procédé selon l'une quelconque des revendications précédentes, dans lequel le ruban de fabrication d'interconnexion électrique (205) est composé d'un matériau argenté, et le troisième contact électrique sur la surface inférieure de chaque cellule solaire (203, 206) est une couche métallique incluant de l'or et/ou de l'argent couvrant tout ou partie de la surface arrière de chaque cellule solaire (203, 206).

4. Procédé selon la revendication 1 comprenant en outre les étapes consistant à :
déplacer automatiquement la première cellule solaire (203) vers une troisième position adjacente à la deuxième position sur l'appareil d'assemblage (201) ; et déplacer simultanément la deuxième cellule solaire (206) vers la deuxième position adjacente à la première position sur l'appareil d'assemblage (201) ;
positionner une troisième cellule solaire adjacente à la deuxième cellule solaire (206) sur l'appareil d'assemblage et répéter le procédé de positionnement automatique d'une troisième partie d'un ruban de fabrication d'interconnexion (205) au-dessus de la troisième cellule solaire positionnée sur le premier appareil d'assemblage (201) ; et
lier automatiquement la troisième partie d'une deuxième interconnexion électrique disposée sur le ruban de fabrication d'interconnexion (205) vers le premier contact électrique sur la troisième cellule solaire.

5. Procédé selon la revendication 4, dans lequel le ruban de fabrication d'interconnexion (205) s'étendant entre la deuxième partie et la troisième partie est conducteur de telle sorte que les première, deuxième et troisième cellules solaires (203, 206) sont électriquement connectées en série.

6. Procédé selon l'une quelconque des revendications précédentes, comprenant en outre l'étape consistant à transférer automatiquement les cellules solaires interconnectées en série vers un deuxième appareil d'assemblage pour montage des cellules solaires interconnectées sur un panneau arrière, lequel est constitué d'un matériau polyester, polyimide, aramide, pyralux ou poly-4,4'-oxydiphénylène-pyromellitimide, et/ou d'une structure maillée ou perforée.

7. Procédé selon la revendication 6, comprenant en outre l'étape consistant à transférer automatiquement les cellules solaires interconnectées montées sur un panneau arrière vers un troisième appareil de fixation pour le montage du panneau arrière sur une structure de support en nid-d'abeilles en aluminium ou une carte de circuit imprimé.

8. Procédé selon la revendication 7, comprenant en outre l'étape consistant à transférer automatiquement les cellules solaires interconnectées montées sur un panneau arrière vers un quatrième appareil de fixation pour le montage d'un verre de protection sur les cellules solaires, le verre de protection étant un verre borosilicaté dopé à l'oxyde de cérium.

9. Procédé selon la revendication 8, dans lequel le quatrième appareil de fixation fournit une couche adhésive entre les cellules solaires et le verre de protection choisie dans le groupe constitué par :
i) un film d'adhésif sensible à la pression, PSA ;
ii) un adhésif thermofusible ; ou
iii) un adhésif siliconé ;
laquelle peut être appliquée au côté inférieur du verre de protection ou à la surface supérieure de la cellule solaire.

10. Procédé selon la revendication 9, comprenant en outre l'étape consistant à transférer automatiquement les cellules solaires interconnectées pourvues d'un verre de protection montées sur un panneau arrière vers un cinquième appareil d'assemblage pour l'assemblage des cellules solaires en un réseau sur un panneau et interconnecter par barres de bus les cellules solaires en un circuit électrique à l'aide des rubans conducteurs ou de pattes.

11. Procédé selon la revendication 10, dans lequel les transferts automatiques des cellules solaires du premier vers le deuxième, troisième, quatrième et cinquième appareils d'assemblage sont réalisés par des tables ou convoyeurs à rouleaux à l'aide d'un alignement visionique selon des marqueurs de centrage.

12. Procédé selon l'une quelconque des revendications précédentes, comprenant en outre une première chaîne linéaire de cellules solaires interconnectées en série provenant des au moins première et deuxième cellules solaires connectées en série pour former la première chaîne ayant une première extrémité et une seconde extrémité opposée ;
positionner automatiquement la première chaîne de cellules solaires interconnectées en série sur une première position d'un appareil d'assemblage ;
fabriquer ensuite une deuxième chaîne linéaire de cellules solaires interconnectées en série ; la deuxième chaîne ayant une première extrémité et une seconde extrémité opposée ;
positionner automatiquement la deuxième chaîne de cellules solaires interconnectées en série sur une deuxième position sur l'appareil d'assemblage de telle sorte que la première chaîne et la deuxième chaîne sont agencées parallèlement et directement adjacentes l'une à l'autre ;
interconnecter électriquement la deuxième extrémité de la première chaîne avec la deuxième extrémité de la deuxième chaîne de telle sorte que les première et deuxième chaînes sont connectées en un circuit électrique en série ; et
répéter les étapes ci-dessus pour produire un réseau rectangulaire.
